Europäisches Patentamt

European Patent Office

Office européen des brevets

(19)

(11) **EP 0 569 740 B1**

(12) **EUROPÄISCHE PATENTSCHRIFT**

(45) Veröffentlichungstag und Bekanntmachung des Hinweises auf die Patenterteilung:
**01.10.1997 Patentblatt 1997/40**

(51) Int Cl.⁶: **G01R 35/04**

(21) Anmeldenummer: **93106436.4**

(22) Anmeldetag: **21.04.1993**

(54) **Verfahren zur selbsttätigen Kalibration von Elektrizitätszählern und Anordnung zur Durchführung des Verfahrens**

Method for automatic calibration of electricity meters and apparatus therefor

Procédé d'étalonnage automatique de compteurs d'électricité et dispositif pour sa mise en oeuvre

(84) Benannte Vertragsstaaten:
**AT CH DE FR GB IT LI**

(30) Priorität: **12.05.1992 CH 1513/92**

(43) Veröffentlichungstag der Anmeldung:
**18.11.1993 Patentblatt 1993/46**

(73) Patentinhaber: **Landis & Gyr Technology Innovation AG**
**6301 Zug (CH)**

(72) Erfinder:
• **Raschle, Ruedi**
  **CH-8820 Wädenswil (CH)**
• **Doebele, Reinhard**
  **CH-6312 Steinhausen (CH)**
• **Koch, Daniel**
  **CH-6300 Zug (CH)**

(56) Entgegenhaltungen:
EP-A- 0 201 019        DE-A- 2 653 898
DE-A- 2 832 656        FR-A- 2 625 323
US-A- 4 600 881

**Beschreibung**

Die Erfindung bezieht sich auf ein Verfahren zur Kalibration von Einphasen-Messeinheiten eines zu kalibrierenden Elektrizitätszahlers gemäss dem Oberbegriff des Anspruchs 1 und einen zu kalibrierenden Elektrizitätszähler zur Durchführung des Verfahrens gemäss Anspruch 12.

Ähnlich wie Ferraris-Elektrizitätszähler werden statische Elektrizitätszähler mit Hilfe einer Referenz kalibriert. Bei Einphasen-Elektrizitätszählern ist dies noch relativ einfach zu verwirklichen. Bei einem Dreiphasen-Elektrizitätszähler sind dagegen bereits drei Abgleichoperationen erforderlich. Bei einem Dreiphasen-Kombinations-Elektrizitätszähler, der z. B. jeweils mindestens einen Dreiphasen-Wirkenergie-Elektrizitätszähler und einen Dreiphasen-Blindenergie-Elektrizitätszähler enthält, verdoppelt sich die Anzahl Abgleichoperationen nochmals, so dass total mindestens sechs Abgleichoperationen erforderlich sind.

Bei heutigen statischen Elektrizitätszählern erfolgen die Abgleichoperationen derart, dass mindestens eine Eingangsgrösse der Elektrizitätszähler, nämlich eine Sannung u und/oder ein Strom i, schaltungstechnisch mittels Trimm-Widerständen oder Trimm-Kapazitäten abgeglichen werden. Dies bedeutet jedoch in der Regel hohe Investitionen für die Fertigung von Elektrizitätszählern. Ausserdem ist der Abgleichvorgang irreversibel. Ein späteres Nachtrimmen der Widerstände oder Kapazitäten ist nur mittels grösserer Eingriffe, z. B. einen Austausch von Komponenten, möglich.

Aus der US-PS 4 600 881 ist eine Anordnung zur Kalibration von Einphasen-Ferraris-Elektrizitätszählem bekannt mit einem Referenz-Elektrizitätszähler, wobei beide Arten von Elektrizitätszählern je eine Impulsfrequenz liefern, die proportional einer jeweils von ihnen gemessenen Leistung ist. Dabei ist die Impulsfrequenz des Referenz-Elektrizitätszählers eine Referenzfrequenz, die mittels eines PLL mit einem Faktor N multipliziert und anschliessend mittels eines Frequenzteilers durch einem Faktor P geteilt wird, wobei in einem Beispiel N = P. Die Referenzfrequenz wird mit dem Faktor N/P multipliziert zur Erzeugung von Impulsen, die ab einem Startaugenblick während eines mittels eines bistabilen Bauelementes erzeugten Zeiffensters gezählt werden, wobei ein so erhaltener Zählwert in einem Speicher eines Rechners gespeichert wird, um anschliessend angezeigt oder ausgedruckt zu werden. Das Zeiffenster ist gleich der Zeit einer Umdrehung einer Rotationsscheibe des zu kalibrierenden Elektrizitätszählers.

Der Erfindung liegt die Aufgabe zugrunde, ein Verfahren zu entwickeln und eine Anordnung zur Durchführung des Verfahrens zu verwirklichen, die auf besonders einfache Weise gestatten, komplexe Elektrizitätszähler, wie Mehrphasen-Elektrizitätszähler und Mehrphasen-Kombinations-Elektrizitätszähler selbsttätig zu kalibrieren.

Vorteile des erfindungsgemässen Verfahrens bzw. der erfindungsgemässen Anordnung sind

- Zuführung eines eine Referenzfrequenz aufweisenden Signals über einen beliebigen, in der Regel bereits vorhandenen Eingang des zu kalibrierenden Elektrizitätszählers, wie z. B. einer CS- oder ZVEI-Schnittstelle oder eines Tarifsteuereinganges,
- Anpassmöglichkeiten an einem beliebigen Referenzsignal durch Verwendung im Elektrizitätszähler eines als Vorfrequenzteiler arbeitenden Frequenzmultiplizierers,
- Mögliche Berücksichtigung von Fehlereinflüssen, z. B. von Fehlereinflüssen extern vorgeschalteter Strom- und/oder Spannungs-Wandlern,
- Möglickeit einer getrennten und gleichzeitigen Kalibration der Wirkenergie- und Blindenergie-Messeinheiten der zu kalibrierenden Elektrizitätszähler,
- Unabhängigkeit des Kalibrationsverfahrens von einem verwendeten speziellen Messverfahren, wie z. B. die Verwendung eines Hallelementes oder eines "Mark Space Modulators" als Multiplizierer,
- individuelle Korrekturmöglichkeit der Einphasen-Messeinheiten der zu kalibrierenden Elektrizitätszähler,
- Kompensationsmöglichkeit von Einflussgrössen, wie z. B. von Einflüssen der Temperatur, der Netzfrequenz und/oder eines Lastkurvenverlaufs bzw. eines Fehlerkennlinienverlaufs,
- gleichzeitige Abgleichmöglichkeit mehrerer Elektrizitätszähler oder mehrerer Einphasen-Messeinheiten in den Elektrizitätszählern,
- Verhinderungsmöglichkeiten von Änderungen der ermittelten Parameterwerte dank der Verwendung eines Schreibschutzes in den Speichern,
- Umschaltmöglichkeit, getrennt nach Phase, von ermittelten Gewichtungsfaktoren in Funktion einer gemessenen Leistung oder eines aktuellen Laststromes und
- vernachlässigbarer Einfluss eines Jitters des Elektrizitätszähler-Übertragwertes, da die Ausgangsfrequenz der Einphasen-Messeinheiten, abhängig vom Verfahren, Werte zwischen 300Hz und 2kHz besitzen und der Übertrag noch einem weiteren als Frequenzvorteiler arbeitenden Frequenzmultiplizierer zugeführt wird.

Die genannte Aufgabe wird erfindungsgemäss durch die im Kennzeichen des Anspruchs 1 angegebenen Merkmale gelöst.

Vorteilhafte Ausgestaltungen der Erfindung ergeben sich aus den abhängigen Ansprüchen.

Ausführungsbeispiele der Erfindung sind in der Zeichnung dargestellt und werden im folgenden näher beschrieben.

Es zeigen:

Fig. 1    ein Blockschaltbild einer Anordnung zu einer Autokalibration eines Einphasen-Elektrizitätszählers,

Fig. 2    ein Blockschaltbild einer Einphasen-Messeinheit eines Wirkenergie-Elektrizitätszählers,

Fig. 3    ein Blockschaltbild einer Einphasen-Messeinheit eines Blindenergie-Elektrizitätszählers,

Fig. 4    ein Blockschaltbild eines als Referenz-Elektrizitätszähler dienenden statischen Einphasen-Wirkenergie-Elektrizitätszählers,

Fig. 5    ein Blockschaltbild einer Gewichtungsfaktor-Ermittlungsanordnung,

Fig. 6    ein Blockschaltbild eines Leistungs-Mess-Sensors,

Fig. 7    ein Blockschaltbild einer Messwert-Ausgabeeinheit,

Fig. 8    ein Schaltbild einer Ausgang-Schnittstellenanordnung eines Referenz-Elektrizitätszählers,

Fig. 9    ein Schaltbild einer Referenzeingang-Schnittstellenanordnung eines zu kalibrierenden Elektrizitätszählers,

Fig.10    ein Diagramm des zeitlichen Verlaufs einer gemessenen Augenblicks-Leistung,

Fig.11    ein Diagramm eines zeitlichen Verlaufs einer innerhalb eines zur Energiemessung verwendeten Signal/Frequenz-Wandlers vorhandenen Kondensatorspannung,

Fig.12    ein Diagramm des zeitlichen Verlaufs des Ausgangssignals des Signal/Frequenz-Wandlers,

Fig.13    ein Diagramm des zeitlichen Verlaufs eines Summiervorgangs innerhalb eines dem Signal/Frequenz-Wandler nachgeschalteten Impulszählers,

Fig.14    ein Diagramm des zeitlichen Verlaufs des Ausgangssignals des Impulszählers,

Fig.15    ein Blockschaltbild einer Anordnung zu einer Autokalibration eines Mehrphasen-Kombinations-Elektrizitätszählers,

Fig.16    ein Blockschaltbild einer Anordnung zu einer rechnerunterstützten Kalibration eines Mehrphasen-Kombinations-Elektrizitätszählers,

Fig.17    ein Blockschaltbild einer Parameter-Messanordnung zur Ermittlung der Werte eines zu einem Parameter, dessen Einfluss zu kompensieren ist, gehörenden Korrekturfaktors,

Fig.18    eine unkorrigierte und zwei korrigierte Fehlerkennlinien eines Elektrizitätszählers in Funktion einer Leistung,

Fig.19    ein Blockschaltbild einer ersten Variante einer Leistungs-Messanordnung zur Ermittlung eines Leistungsbereichs, in dem sich ein zur gemessenen Energie gehörender Wert der Leistung befindet, und

Fig.20    ein Blockschaltbild einer zweiten Variante einer Leistungs-Messanordnung zur Ermittlung eines Leistungsbereichs, in dem sich ein zur gemessenen Energie gehörender Wert der Leistung befindet.

Gleiche Bezugszahlen bezeichnen in allen Figuren der Zeichnung gleiche Teile.

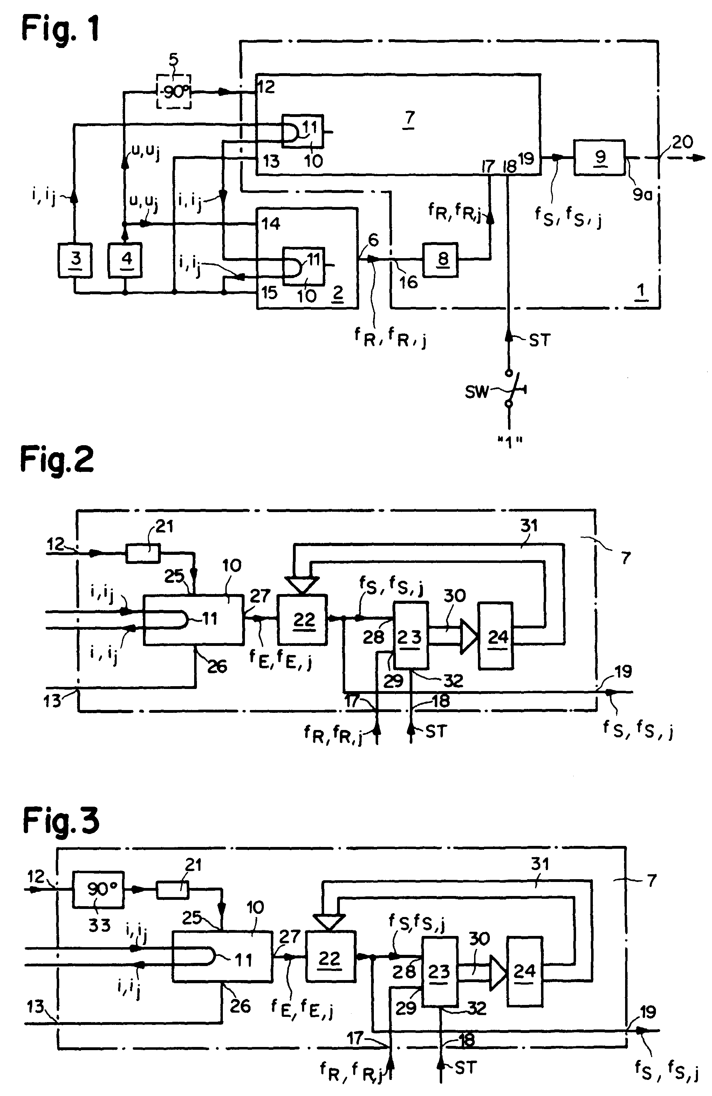

Der in der Fig. 1 dargestellte Aufbau einer Anordnung zur Autokalibration eines Einphasen-Elektrizitätszählers 1 enthält ausser dem letzteren noch einen Referenz-Elektrizitätszähler 2, eine Stromquelle 3, eine Spannungsquelle 4 sowie fakultativ einen Phasenschieber 5. Die Stromquelle 3 und die Spannungsquelle 4 sind vorzugsweise einphasige Wechselstrom-Quellen, können aber auch mehrphasige Wechselstrom-Quellen sein.

Der Referenz-Elektrizitätszähler 2 besitzt einen Impulsausgang 6 und ist ansonsten ein beliebiger, eine genügende Genauigkeit aufweisender Präzisions-Elektrizitätszähler, z. B. ein bekannter Ferrari-Elektrizitätszähler mit Drehscheibe und Ausgangsimpulsgeber oder ein statischer Elektrizitätszähler mit Impulsausgang. Nachfolgend gilt die Annahme das letzteres der Fall ist und dass, zur Vereinfachung der nachfolgenden Funktionsbeschreibung, sein Eingangsteil prinzipiell ähnlich aufgebaut ist wie derjenige eines zu kalibrierenden statischen Elektrizitätszählers. Der Referenz-Elektrizitätszähler 2 misst eine vorgegebene Energieart, z. B., wie in der Zeichnung und der nachfolgenden Beschreibung angenommen, eine Wirkenergie. Er ist ausserdem vorzugsweise, wie nachfolgend angenommen, ein Einphasen-Referenz-Elektrizitätszähler, was in der Praxis in der Regel der Fall ist, aber nicht unbedingt zu sein braucht. Eine Impulsfrequenz des Referenz-Elektrizitätszählers 2, nämlich die Frequenz von an seinem Impulsausgang 6 anstehenden Impulsen, stellt eine Referenzfrequenz $f_R$ bzw. $f_{R,j}$ dar, mit $j = 1, 2, 3$ und $4$. Die Bedeutung von j wird später noch erläutert werden.

Alle zu kalibrierenden Elektrizitätszähler enthalten je eine Einphasen-Messeinheit 7 pro Phase, eine Referenzeingang-Schnittstellenanordnung 8 und eine Messwert-Ausgabeeinheit 9. Der Referenz-Elektrizitätszähler 2 und die Einphasen-Messeinheiten 7 besitzen je einen Leistungs-Mess-Sensor 10, der jeweils eine U-förmige Stromschlaufe 11 als Stromeingang aufweist. Dieser ist dann auch jeweils ein Stromeingang des Referenz-Elektrizitätszählers 2 bzw. der Einphasen-Messeinheiten 7. Jede Einphasen-Messeinheit 7 besitzt ausserdem einen zweipoligen Spannungseingang 12;13, während der Referenz-Elektrizitätszähler 2 einen zweipoligen Spannungseingang 14;15 aufweist.

In der erfindungsgemässen Anordnung werden die Stromeingänge, d. h. die Stromschlaufen 11, des Referenz-Elektrizitätszählers (2) und der Einphasen-Messeinheiten 7 unmittelbar oder über Phasenschieber, z. B. über den Phasenschieber 5, mit Eingangsströmen i oder $i_j$ gleicher Frequenz und gleicher Amplitude und die Spannungseingänge 14;15 bzw. 12;13 des Referenz-Elektrizitätszählers 2 und der Einphasen-Messeinheiten 7 unmittelbar oder über Phasenschieber, z. B. über den Phasenschieber 5, mit Eingangsspannungen u oder $u_j$ gleicher Frequenz und gleicher Amplitude so gespeist, dass der Referenz-Elektrizitätszähler 2 und die Einphasen-Messeinheiten 7 jeweils einen gleichen Leistungswert $p = u.i$ bzw. $p_j = u_j.i_j$ einer gleichen Energieart, z. B. einer Wirkenergie, messen.

Nachfolgend gilt die Annahme, dass einer der beiden Eingänge 11 bzw. 14;15 oder 12;13 des Referenz-Elektrizitätszählers 2 und einer jeden Einphasen-Messeinheit 7 mit einem gleichen Strom i oder $i_j$ bzw. einer gleichen Spannung u oder $u_j$ gespeist ist und dass der andere der beiden Eingänge 14;15 oder 12;13 bzw. 11 mit einer eine gleiche Amplitude und eine gleiche Frequenz aufweisende Spannung bzw. mit einem eine gleiche Amplitude und eine gleiche Frequenz aufweisenden Strom gespeist ist. Dies geschieht vorzugsweise, indem einerseits die Stromquelle 3 elektrisch in Reihe geschaltete U-förmige Stromschlaufen 11 der Einphasen-Messeinheiten 7 und des Referenz-Elektrizitätszählers 2 mit dem gleichen Strom i bzw. $i_j$ speist und andererseits die Spannungsquelle 4 die zweipoligen Spannungseingänge 12;13 der Einphasen-Messeinheiten 7 und 14;15 des Referenz-Elektrizitätszählers 2 entweder unmittelbar oder über mindestens einen Phasenschieber 5 mit der gleichen Spannung u bzw. $u_j$ speist, und zwar so, dass sowohl die Einphasen-Messeinheiten 7 als auch der Referenz-Elektrizitätszähler 2 je eine gleiche Wirkenergie messen. D. h. zum Beispiel, dass der Phasenschieber 5 abwesend ist, wenn der Einphasen-Elektrizitätszähler 1 ein Wirkenergie-Elektrizitätszähler ist, und dass er vorhanden ist, wenn der Einphasen-Elektrizitätszähler 1 ein Blindenergie-Elektrizitätszähler ist, dies immer unter der Annahme, dass der Referenz-Elektrizitätszähler 2 ein Wirkenergie-Elektrizitätszähler ist.

Bei der Kalibration des Einphasen-Elektrizitätszählers 1 speist dann, wie in der Fig. 1 dargestellt, die Stromquelle 3 die beiden in Reihe geschalteten Stromschlaufen 11 der einzigen Einphasen-Messeinheit 7 und des Referenz-Elektrizitätszählers 2 mit dem Strom i bzw. $i_j$. Die Spannungsquelle 4 speist unmittelbar den zweipoligen Spannungseingang 14;15 des Referenz-Elektrizitätszählers 2 und unmittelbar, falls der Einphasen-Elektrizitätszähler 1 ein Wirkenergie-Elektrizitätszähler ist, oder über den Phasenschieber 5, falls der Einphasen-Elektrizitätszähler 1 ein Blindenergie-Elektrizitätszähler ist, den zweipoligen Spannungseingang 12;13 der Einphasen-Messeinheit 7 des Elektrizitätszählers 1 mit der Spannung u bzw. $u_j$. Dabei sind je ein Pol der Stromquelle 3 und der Spannungsquelle 4 sowie die Pole 13 und 15 des zweipoligen Spannungseingangs 12;13 bzw. 14;15 elektrisch miteinander verbunden und liegen an einem gemeinsamen Bezugspotential. Der zu kalibrierende Elektrizitätszähler 1 besitzt einen Referenzsignal-Eingang 16, der mit dem Impulsausgang 6 des Referenz-Elektrizitätszählers 2 verbunden ist. Der Referenzsignal-Eingang 16 wird mit Impulsen, die am Impulsausgang 6 des Referenz-Elektrizitätszählers 2 anstehen, gespeist und ist intern im Elektrizitätszähler 1 über die Referenzeingang-Schnittstellenanordnung 8 mit einem Referenzsignal-Eingang 17 der Einphasen-Messeinheit 7 verbunden. Er ist z. B. ein Tarifsteuereingang, ein Eingang einer mittels einer Leuchtdiode aufgebauten optischen Einlese-Schnittstelle oder ein Eingang einer normierten CS-Schnittstelle ("current serial interface", auch manchmal "current loop interface" genannt) oder einer normierten ZVEI-Schnittstelle des Elektrizitätszählers 1. Ein externes Steuersignal ST ist auf einen Steuereingang 18 der Einphasen-Messeinheit 7 des Elektrizitätszählers 1 geführt, während ein Frequenzausgang 19 der Einphasen-Messeinheit 7 mit einem Eingang der Messwert-Ausgabeeinheit 9 verbunden ist, welche zu Fernzählzwecken fakultativ einen Ausgang 9a besitzt, der, falls vorhanden, auf einen Fernzählausgang 20 des Elektrizitätszählers 1 geführt ist. Bei einer Autokalibration wird das externe Steuersignal ST im Startaugenblick z. B. mittels eines Schalters SW erzeugt, der dann einen Logikwert "1" auf den Steuereingang 18 der Einphasen-Messeinheit 7 schaltet.

Der Leistungs-Mess-Sensor 10 enthält immer einen Multiplizierer, der z. B. ein Hallelement oder ein Pulsdauer-Pulslücken-Modulator (sogenannter "Mark space modulator") ist. Zur Vereinfachung der Beschreibung und der Zeichnung gilt nachfolgend immer die Annahme, dass der Multiplizierer ein Hallelement ist, wobei jedoch klar ist, dass das Hallelement auch durch einen anderen beliebigen Multiplizierer ersetzt werden kann, da das erfindungsgemässe Verfahren und die erfindungsgemässe Anordnung unabhängig von der Art des gewählten Multiplizierers ist.

Wenn der Einphasen-Elektrizitätszähler 1 ein Wirkenergie-Elektrizitätszähler ist, dann besitzt die Einphasen-Messeinheit 7 den in der Fig. 2 dargestellten Aufbau. Jede Einphasen-Messeinheit 7 enthält in diesem Fall neben dem Leistungs-Mess-Sensor 10 mit seiner U-förmigen Stromschlaufe 11 vorzugsweise noch einen Vorwiderstand 21, einen Frequenzmultiplizierer 22, eine Gewichtungsfaktor-Ermittlungsanordnung 23, die der Ermittlung der Werte eines Kalibrationsfaktors $K_g$ dient, und einen Speicher 24. Der letztere ist vorzugsweise ein sogenannter unverlierbarer Speicher, der bei Spannungsausfall seinen Speicherinhalt nicht verliert, und z. B. ein $E^2$PROM-Speicher. Zur Erhöhung der Datensicherheit besitzt der Speicher 24 vorzugsweise einen Hardware-Schreibschutz, dessen Sperrung im Startaugenblick z. B. durch das externe Steuersignal ST aufhebbar ist. Der Hardware-Schreibschutz verhindert als Schreibsperre Schreiboperationen des Speichers 24, wenn z. B. ein im Elektrizitätszähler 1 enthaltener Mikrocomputer aussertakt gerät oder wenn durch Störungen bei möglichen Fehlfunktionen des Elektrizitätszählers 1 Schreiboperationen ausgelöst werden. Ein Pol 12 des zweipoligen Spannungseingangs 12;13 der Einphasen-Messeinheit 7 ist über den Vorwiderstand 21 mit einem ersten Pol 25 eines Speisestromeingangs 25;26 des Leistungs-Mess-Sensors 10 verbunden, während ein zweiter Pol 26 des Speisestromeingangs 25;26 mit dem Pol 13 des zweipoligen Spannungseingangs 12;13 der Einphasen-Messeinheit 7 verbunden ist. Ein Frequenzausgang 27 des Leistungs-Mess-Sensors 10 ist auf einen Signaleingang des Frequenzmultiplizierers 22 geführt, so dass dessen Eingangssignal eine Impulsfrequenz $f_E$ bzw. $f_{E,j}$ besitzt, die proportional der durch den betreffenden Leistungs-Mess-Sensor 10 und damit auch durch die betreffende Einphasen-Messeinheit 7 gemessene Leistung ist. Der Ausgang des Frequenzmultiplizierers 22, an dem eine kalibrierte Frequenz $f_S$ bzw. $f_{S,j}$ ansteht, ist einerseits auf einen Signaleingang 28 der nachgeschalteten Gewichtungsfaktor-Ermittlungsanordnung 23 und anderseits auf den Frequenzausgang 19 der Einphasen-Messeinheit 7 geführt. Der Referenzsignal-Eingang 17 der letzteren ist mit einem Referenzsignal-Eingang 29 der Gewichtungsfaktor-Ermittlungsanordnung 23 verbunden, so dass der Referenzsignal-Eingang 29 vom Impulsausgang 6 des Referenz-Elektrizitätszählers 2 über die Referenz-Schnittstellenanordnung 8 mit einem Signal gespeist ist, welches als Frequenz die Referenzfrequenz $f_R$ bzw. $f_{R,j}$ besitzt. Der Ausgang der Gewichtungsfaktor-Ermittlungsanordnung 23 ist über eine erste Busverbindung 30 auf einen Schreibeingang des Speichers 24 geführt, dessen Ausgang über eine zweite Busverbindung 31 mit einem weiteren Eingang, nämlich einem Buseingang, des Frequenzmultiplizierers 22 verbunden ist. Der Steuereingang 18 der Einphasen-Messeinheit 7 ist auf einen Steuereingang 32 der Gewichtungsfaktor-Ermittlungsanordnung 23 geführt.

Wenn der Elektrizitätszähler 1 ein Blindenergie-Elektrizitätszähler ist, dann besitzt die Einphasen-Messeinheit 7 den in der Fig. 3 dargestellten Aufbau. Sie ist ähnlich aufgebaut wie die in der Fig. 2 dargestellte Einphasen-Messeinheit 7 und enthält als einzigen Unterschied nur noch zusätzlich einen 90°-Phasenschieber 33. Dabei ist der Pol 12 des zweipoligen Spannungseingangs 12;13 der Einphasen-Messeinheit 7 in der angegebenen Reihenfolge über den 90°-Phasenschieber 33 und den Vorwiderstand 21 mit dem Pol 25 des Speisestromeingangs 25;26 des Leistungs-Mess-Sensors 10 verbunden. Zur Messung der Blindleistung muss bekanntlich eine, hier durch den 90°-Phasenschieber 33 verursachte 90°-Phasenverschiebung zwischen der Spannung u bzw. $u_j$ und dem Strom i bzw. $i_j$ vorhanden sein.

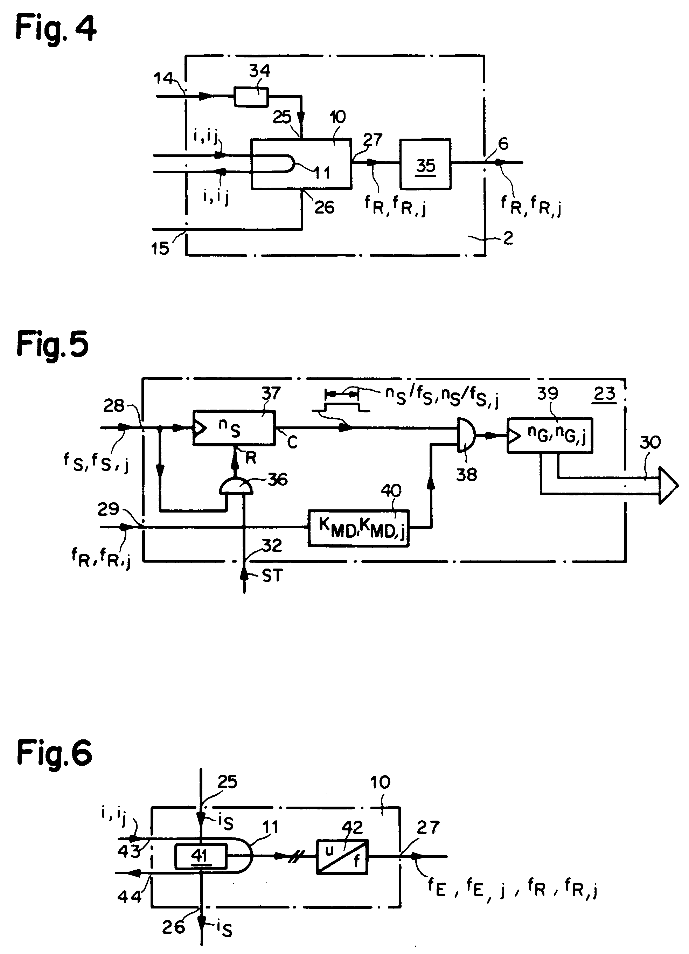

Wenn der Referenz-Elektrizitätszähler 2 ein statischer Einphasen-Wirkenergie-Elektrizitätszähler ist, dann besitzt er den in der Fig. 4 dargestellten Aufbau und enthält in diesem Fall neben dem Leistungs-Mess-Sensor 10 mit seiner U-förmigen Stromschlaufe 11 noch vorzugsweise einen Vorwiderstand 34 und eine Ausgang-Schnittstellenanordnung 35. Ein Pol 14 des zweipoligen Spannungseingangs 14;15 des Referenz-Elektrizitätszählers 2 ist innerhalb des letzteren über den Vorwiderstand 34 auf den ersten Pol 25 des Speisestromeingangs 25;26 des Leistungs-Mess-Sensors 10 geführt, während der zweite Pol 26 des Speisestromeingangs 25;26 mit dem Pol 15 des zweipoligen Spannungseingangs 14;15 verbunden ist. Der Frequenzausgang 27 des Leistungs-Mess-Sensors 10 ist über die Ausgang-Schnittstellenanordnung 35 auf den Impulsausgang 6 des Referenz-Elektrizitätszählers 2 geführt.

Das erfindungsgemässe Kalibrationsverfahren kann entweder mittels Hardware, was in der Fig. 2 und in der Fig. 3 angenommen wurde, oder, falls ein Computer, vorzugsweise ein Mikrocomputer, im Elektrizitätszähler 1 vorhanden ist, mittels Software verwirklicht werden. Im ersteren Fall ist die Gewichtungsfaktor-Ermittlungsanordnung 23 vorhanden, die vorzugsweise den in der Fig. 5 dargestellten Aufbau besitzt. Die Gewichtungsfaktor-Ermittlungsanordnung 23 enthält in diesem Fall ein erstes Freigabegatter 36, einen ersten Zähler 37, ein zweites Freigabegatter 38, einen zweiten Zähler 39 und einen eigenen Frequenzmultiplizierer 40. Die beiden Freigabegatter 36 und 38 sind z. B. je ein mit zwei Eingängen versehenes Und-Gatter. Innerhalb der Gewichtungsfaktor-Ermittlungsanordnung 23 ist deren Signaleingang 28 auf einen Takteingang des ersten Zählers 37 und auf einen ersten Eingang des ersten Freigabegatters 36 geführt, dessen zweiter Eingang vom externen Steuersignal ST über den Steuereingang 32 der Gewichtungsfaktor-Ermittlungsanordnung 23 gespeist und dessen Ausgang mit einem Rückstell-Eingang R des ersten Zählers 37 verbunden ist. Der Referenzsignal-Eingang 29 ist über den Frequenzmultiplizierer 40 mit einem ersten Eingang des zweiten Freigabegatters 38 verbunden, während ein zweiter Eingang des letzteren mit einem Übertrag-Ausgang C ("carry") des ersten Zählers 37 verbunden ist. Der Ausgang des zweiten Freigabegatters 38 ist auf einen Takteingang des zweiten Zählers 39 geführt, dessen Parallelausgang an der ersten Busverbindung 30 angeschlossen ist, die einen Ausgang der Gewichtungsfaktor-Ermittlungsanordnung 23 bildet.

Der in der Fig. 6 dargestellte Leistungs-Mess-Sensor 10 enthält zusätzlich zur U-förmigen Stromschlaufe 11 vorzugsweise ein Hallelement 41 als Multiplizierer, dessen zweipoliger Speisestromeingang dem zweipoligen Speisestromeingang 25;26 des Leistungs-Mess-Sensors 10 entspricht und von einem Speisestrom $i_S$ gespeist ist. Der zweipolige Hallspannungsausgang des Hallelementes 41 ist innerhalb des Leistungs-Mess-Sensors 10 auf einen Eingang eines Signal/Frequenz-Wandlers 42 geführt, dessen Frequenzausgang seinerseits mit dem Frequenzausgang 27 des Leistungs-Mess-Sensors 10 verbunden ist. Wenn der Multiplizierer ein Hallelement 41 ist, ist der Signal/Frequenz-Wandler 42 ein Spannungs/Frequenz-Wandler, was in der Fig. 6 angenommen wurde. Andernfalls kann er auch ein Strom/Frequenz-Wandler sein. In jedem Leistungs-Mess-Sensor 10 ist das Hallelement 41 jeweils räumlich zwischen dem Hinleiter und dem Rückleiter der zugehörigen U-förmigen Stromschlaufe 11 angeordnet. Die beiden elektrischen Anschlüsse der U-förmigen Stromschlaufe 11 bilden jeweils einen zweipoligen Stromeingang 43;44 des zugehörigen Leistungs-Mess-Sensors 10, wobei der Strom i bzw. $i_j$ bei einem Pol, z. B. einem Pol 43, des zweipoligen Stromeingangs 43;44 in die U-förmige Stromschlaufe 11 des Leistungs-Mess-Sensors 10 hineinfliesst und bei dem andern Pol, z. B. einem Pol 44, wieder hinausfliesst. Der Strom i bzw. $i_j$ erzeugt dabei im Hallelement 41 ein proportionales Magnetfeld, so dass am Hallspannungs-Ausgang des Hallelementes 41 eine Hallspannung entsteht, die proportional dem Produkt des Magnetfeldes, und damit des Stromes i bzw. $i_j$, sowie des Speisestromes $i_S$ ist. Die Hallspannung wird ihrerseits im Signal/Frequenz-Wandler 42 in eine proportionale Impulsfrequenz $f_E$ oder $f_{E,j}$ (Elektrizitätszähler 1) bzw. $f_R$ oder $f_{R,j}$ (Referenz-Elektrizitätszähler 2) rechteckförmiger Impulse umgewandelt, die somit ebenfalls proportional dem Produkt i.$i_S$ bzw. $i_j.i_S$ ist. Da, wie noch später erläutert wird, der Speisestrom $i_S$ proportional der Spannung u bzw. $u_j$ der Spannungsquelle 4 ist, ist die am Ausgang des Leistungs-Mess-Sensors 10 anstehende Frequenz $f_E$ bzw. $f_R$ oder $f_{E,j}$ bzw. $f_{R,j}$ auch proportional der in der betreffenden Einphasen-Messeinheit 7 des Elektrizitätszählers 1 bzw. im Referenz-Elektrizitätszähler 2 gemessenen Leistung $p = u.i$ oder $p_j = u_j.i_j$. Da jede Einphasen-Messeinheit 7 und der Referenz-Elektrizitätszähler 2 einen Leistungs-Mess-Sensor 10 enthalten, weisen der Referenz-Elektrizitätszähler 2 und jede Einphasen-Messeinheit 7 auch je eine Impulsfrequenz $f_E$ bzw. $f_R$ oder $f_{E,j}$ bzw. $f_{R,j}$ auf.

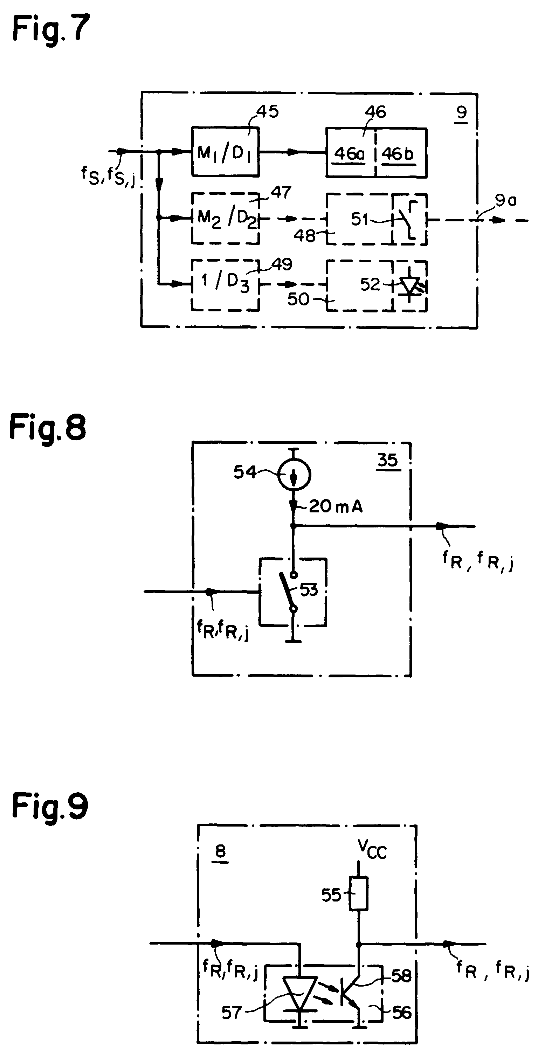

Die in der Fig. 7 dargestellte Messwert-Ausgabeeinheit 9 enthält einen ersten Frequenzmultiplizierer 45, eine Anzeige 46 sowie jeweils fakultativ und daher in der Fig. 7 gestrichelt dargestellt einen zweiten Frequenzmultiplizierer 47, eine elektrische Impuls-Ausgangsschaltung 48, einen dritten Frequenzmultiplizierer 49 und eine optische Impuls-Ausgangsschaltung 50. Der Eingang der Messwert-Ausgabeeinheit 9 ist innerhalb der letzteren auf je einen Eingang der drei Frequenzmultiplizierer 45, 47 und 49 geführt, soweit vorhanden. Der Ausgang des ersten Frequenzmultiplizierers 45 ist mit einem Eingang der Anzeige 46 verbunden, die z. B. einen Eingangszähler 46a und eine nachgeschaltete Digitalanzeige 46b enthält. Die Anzeige 46 ist ein bekanntes elektromechanisches Zählwerk oder eine Flüssigkristallanzeige, der ein Zähler vorgeschaltet ist. Der Ausgang des zweiten Frequenzmultiplizierers 47 ist gegebenenfalls mit einem Eingang der elektrischen Impuls-Ausgangsschaltung 48 verbunden, die an ihrem Ausgang einen Schaltkontakt 51 aufweist, der auf den Ausgang 9a der Messwert-Ausgabeeinheit 9 und damit auf den Fernzählausgang 20 des Elektrizitätszählers 1 geführt ist (siehe Fig. 1). Der Fernzählausgang 20 dient z. B. einer seriellen Fernmessung, d. h. einer zeitseriellen Bit für Bit modulierten oder unmodulierten Fernübertragung der gemessenen Energiewerte. Der Ausgang des dritten Frequenzmultiplizierers 49 ist gegebenenfalls mit einem Eingang der optischen Impuls-Ausgangsschaltung 50 verbunden, die an ihrem Ausgang eine von ausserhalb des Elektrizitätszählers 1 sichtbare Leuchtdiode 52 aufweist. Die Leuchtdiode 52 emittiert sichtbares Licht oder Infrarot-Licht und dient z. B. einem zeitseriellen optischen Bit für Bit Lesen der gemessenen Energiewerte. Die Anzeige 46 zeigt ihrerseits die gemessenen Energiewerte unmittelbar an, z. B. auf der Frontplatte des Elektrizitätszählers 1.

Die vier Frequenzmultiplizierer 40, 45, 47 und 49 sind vorzugsweise bekannte sogenannte "Rate multiplier", die jeweils ihre eigenen Eingangsimpulse zählen und dann den Wert der Frequenz der letzteren mit einer Bruchzahl M/D bzw. $M_1/D_1$ bzw. $M_2/D_2$ bzw. $M_3/D_3$ multiplizieren, die kleiner oder gleich 1 ist. Im erfindungsgemässen Verfahren ist $M_3/D_3$ z. B. gleich $1/D_3$. Der Frequenzmultiplizierer 49 arbeitet in diesem Fall als reiner Frequenzteiler.

Die Ausgang-Schnittstellenanordnung 35 des Referenz-Elektrizitätszählers 2 ist z. B. eine normierte CS-Schnittstelle und besitzt dann den in der Fig. 8 dargestellten Aufbau. Sie enthält in diesem Fall am Ausgang einen Schalter 53, der von einer Stromquelle 54 mit einem normierten Stromwert von 20 mA gespeist wird. Innerhalb der Ausgang-Schnittstellenanordnung 35 ist deren Eingang auf einen Steuereingang des Schalters 53 geführt, während ein nicht an Masse liegender gemeinsamer Pol des Schalters 53 und der Stromquelle 54 auf einen Ausgang der Ausgang-Schnittstellenanordnung 35 und damit auf den Impulsausgang 6 des Referenz-Elektrizitätszählers 2 geführt ist. Der andere gemeinsame Pol des Schalters 53 und der Stromquelle 54 liegt z. B. an Masse. Der Schaltkontakt 51 und der Schalter 53 sind dabei z. B. Schaltkontakte je eines elektromagnetischen Relais oder je eines Halbleiterschalters.

Die Referenzeingang-Schnittstellenanordnung 8 des zu kalibrierenden Elektrizitätszählers 1 ist z. B. eine zur normierten CS-Schnittstelle gehörende Empfangsschaltung und besitzt dann den in der Fig. 9 dargestellten Aufbau. Sie enthält in diesem Fall einen Widerstand 55 und einen Optokoppler 56, der bekanntlich aus einer Leuchtdiode 57 und einem Phototransistor 58 besteht. Innerhalb der Referenzeingang-Schnittstellenanordnung 8 ist deren Eingang auf einen Pol der Leuchtdiode 57 geführt, deren anderer Pol sowie der Emitter des Phototransistors 58 z. B. an Masse liegen. Ein nicht an Masse liegender Pol einer Gleichspannung $V_{cc}$ ist über den Widerstand 55 mit dem Kollektor des Phototransistors 58 sowie mit dem Ausgang der Referenzeingang-Schnittstellenanordnung 8 verbunden, während der andere Pol der Gleichspannung $V_{cc}$ an Masse liegt.

Wenn einer der beiden Elektrizitätszähler 1 und 2 ein Blindenergie-Elektrizitätszähler ist, dann ist auch der Phasenschieber 5 vorhanden, der, wenn der Referenz-Elektrizitätszähler 2 ein Wirkenergie-Elektrizitätszähler ist, dem 90°-Phasenschieber 33 (siehe Fig. 3) des in diesem Fall Blindenergie-Elektrizitätszählers 1 in einer Kettenschaltung vorgeschaltet ist. Die Spannung u bzw. $u_j$ der Spannungsquelle 4 speist dann in der angegebenen Reihenfolge, über den Phasenschieber 5, den 90°-Phasenschieber 33 und den Vorwiderstand 21 den Speisestromeingang 25;26 des Leistungs-Mess-Sensors 10 des Elektrizitätszählers 1. Der Phasenschieber 5 verursacht dabei eine Phasenverschiebung von -90° und annulliert die durch den 90°-Phasenschieber 33 verursachte Phasenverschiebung von 90°, so dass die in den beiden Vorwiderständen 21 und 34 fliessenden Speiseströme der Hallelemente 41 der beiden Elektrizitätszähler 1 und 2 phasengleich sind. Wenn die Elektrizitätszähler 1 und 2 dagegen beide Wirkenergie-Elektrizitätszähler sind, dann sind die beiden Phasenschieber 5 und 33 nicht vorhanden. In jedem Fall ist jedoch der in den beiden Vorwiderständen 21 und 34 fliessende Speisestrom des zugehörigen Hallelementes 41 proportional der Spannung u bzw. $u_j$. Die Vorwiderstände 21 und 34 sind beide hochohmig, so dass die Bauelemente-Kombinationen 4;5;33;21, wenn die beiden Phasenschieber 5 und 33 vorhanden sind, bzw. 4;21, wenn die beiden Phasenschieber 5 und 33 nicht vorhanden sind, sowie 4;34 je als Stromquelle arbeiten. Jeder Leistungs-Mess-Sensor 10 ist eingestellt auf einen bestimmten Arbeitspunkt mittels des Vorwiderstandes 21 bzw. 34. Die Ausgangsspannungen der Hallelemente 41 sowie die Ausgangsfrequenzen $f_E$ bzw. $f_R$ oder $f_{E,j}$ bzw. $f_{R,j}$ der Leistungs-Mess-Sensoren 10 der beiden Elektrizitätszähler 1 und 2 sind jeweils proportional dem gleichen Produkt u.i bzw. $u_j.i_j$ und damit proportional der von beiden Elektrizitätszählern 1 und 2 gemessenen gleichen Leistung u.i bzw. $u_j.i_j$.

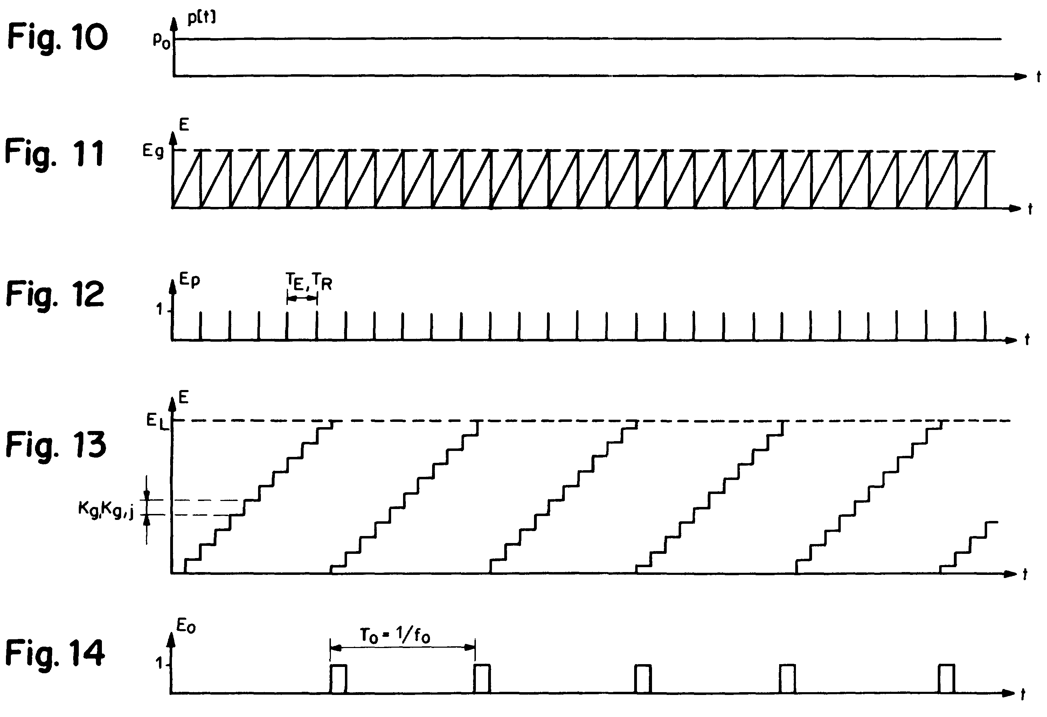

In der Fig. 10 ist ein Diagramm des zeitlichen Verlaufs einer gemessenen Augenblicks-Leistung p[t] = u.i bzw. p[t] = $u_j.i_j$ in Funktion der Zeit t dargestellt, wobei aus Gründen der zeichnerischen Einfachheit angenommen wurde, dass p[t] = $p_o$ und somit in Funktion der Zeit t konstant ist. Die Hallspannung des Hallelementes 41 ist in beiden Elektrizitätszählern 1 und 2 proportional dieser Leistung. Im zugehörigen Signal/Frequenzwandler 42 wird dann die Hallspannung in einen proportionalen Strom umgewandelt, der einen Kondensator eines Integrators lädt. Die Kondensatorspannung entspricht dabei dem Zeitintegral von p[t].dt und damit der im betreffenden Zeitintervall gemessenen Energie E. Im Fall von p[t] = $p_o$ steigt der Wert der gemessenen Energie E in Funktion der Zeit t linear an bis zum Erreichen eines Schwellwertes Eg (siehe Fig. 11). Jedesmal, wenn die gemessene Energie E den letzteren erreicht, wird der Kondensator des Integrators, unter gleichzeitiger Abgabe eines eine Energie $E_p$ darstellenden rechteckför-migen Impulses an den Ausgang des Signal/Frequenz-Wandlers 42 und damit an den Frequenzausgang 27 des zugehörigen Leistungs-Mess-Sensors 10, auf Null entladen, um anschliessend wieder durch die Hallspannung linear aufgeladen zu werden. Es entsteht auf dieser Art in Funktion der Zeit t für die Kondensatorspannung und damit auch für die gemessene Energie E eine sägezahnförmige Kennlinie, welche in der Fig. 11 dargestellt ist. In der Fig. 12 sind die die Energie $E_p$ pro Impuls darstellenden Impulse dargestellt, welche im Laufe der Zeit t jedesmal dann am Frequenzausgang 27 des Leistungs-Mess-Sensors 10 erscheinen, wenn die gemessene Energie E den Schwellwert $E_g$ erreicht. Die die Energie $E_p$ pro Impuls darstellenden rechteckförmigen Impulse besitzen einen Logikwert 1 als Amplitude und eine Periode $T_E$ = $1/f_E$ bzw. $l/f_{E,j}$ im Elektrizitätszähler 1 bzw. $T_R$ = $1/f_R$ bzw. $1/f_{R,j}$ im Referenz-Elektrizitätszähler 2, wobei jeweils $f_E$ und $f_{E,j}$ bzw. $f_R$ und $f_{R,j}$ die Ausgangsfrequenz des betreffenden Leistungs-Mess-Sensors 10 ist, welche ihrerseits, wie bereits erwähnt, jeweils proportional der gemessenen Leistung u.i bzw. $u_j.i_j$ ist.

Die am Frequenzausgang 27 des Leistungs-Mess-Sensors 10 des Referenz-Elektrizitätszählers 2 anstehenden rechteckförmigen Impulse der Frequenz $f_R$ bzw. $f_{R,j}$ erreichen über die Ausgang-Schnittstellenanordnung 35 (siehe Fig. 4), in der sie spannungs-und/oder strommässig an die Eingangsbedingungen des Referenzsignal-Eingangs 16 des Elektrizitätszählers 1 angepasst werden, den Impulsausgang 6, welcher seinerseits über den Referenzsignal-Eingang 16 des Elektrizitätszählers 1 mit der Referenzeingang-Schnittstellenanordnung 8 verbunden ist (siehe Fig. 1), in der die rechteckförmigen Impulse spannungs- und/oder strommässig an die Eingangsbedingungen des Referenzsignal-Eingangs 17 der Einphasen-Messeinheit 7 angepasst werden, ohne dass dabei deren Frequenz $f_R$ bzw. $f_{R,j}$ geändert wird.

Jeder die Energie $E_p$ darstellende Impuls des Elektrizitätszählers 1 entspricht einer gemessenen unkalibrierten festen Energiemenge $E_g$, da:

$$E_g = \int_0^{T_E} p[t].dt, \text{ mit } p[t] = u.i \text{ bzw. mit } p[t] = u_j.i_j.$$

Der wirkliche, d. h. der kalibrierte Energiewert $E_w$ pro Impuls des Elektrizitätszählers 1 ist aber:

$$E_w = K_g.E_p \text{ bzw. } E_w = K_{g,j} \cdot E_p,$$

wobei $K_g$ bzw. $K_{g,j}$ ein Gewichtungsfaktor ist und einen Kalibrationsfaktor darstellt. Daher muss die Ausgangsfrequenz $f_E$ bzw. $f_{E,j}$ des Leistungs-Mess-Sensors 10 des Elektrizitätszählers 1 im Frequenzmultiplizierer 22 (siehe Fig. 2 und Fig. 3) mit dem Kalibrationsfaktor $K_g$ bzw. $K_{g,j}$ multipliziert werden, dessen Wert, bei Spannungsunterbruch unverlierbar, im Speicher 24 gespeichert ist und über die zweite Busverbindung 31 dem Frequenzmultiplizierer 22 zugeführt wird.

Die gesamte wirkliche, im Laufe einer gegebenen Zeit gemessene kalibrierte Energie ist E = $\Sigma$ $K_g.E_p$ bzw. E = $\Sigma$ $K_{g,j}.E_p$, wobei das Summenzeichen $\Sigma$ sich auf alle während dieser Zeit am Frequenzausgang 27 des Leistungs-Mess-Sensors 10 des Elektrizitätszählers 1 erscheinenden Impulse bezieht.

Zwecks Einsparung von rechenzeitintensiven Multiplikationen wird $E_p$ = 1 gewählt, so dass

$$E_w = K_g \text{ bzw. } E_w = K_{g,j} \text{ und } E = \Sigma K_g \text{ bzw. } E = \Sigma K_{g,j} \tag{1}$$

Die Energie E hat dann in Funktion der Zeit t den in der Fig. 13 dargestellten treppenförmig ansteigenden Verlauf, wobei die Höhe einer jeden Treppenstufe den Wert des Kalibrationsfaktors $K_g$ bzw. $K_{g,j}$ besitzt. Der Elektrizitätszähler 1 muss in diesem Fall bei jedem Ausgangsimpuls seines Leistungs-Mess-Sensors 10 lediglich nur mehr eine Addition durchführen zwecks Ermittlung des Wertes der Energie E. Zu diesem Zweck wird die Ausgangsfrequenz $f_E$ bzw. $f_{E,j}$ des Leistungs-Mess-Sensors 10 des Elektrizitätszählers 1 im Frequenzmultiplizierer 22 mit dem Kalibrationsfaktor $K_g$ bzw. $K_{g,j}$ multipliziert zwecks Erhalt einer Frequenz $f_S$ bzw. $f_{S,j}$, die anschliessend der Gewichtungsfaktor-Ermittlungsanordnung 23 und über den Frequenzausgang 19 der Messwert-Ausgabeeinheit 9 zugeführt wird, wo ihre Impulse einerseits im ersten Zähler 37 der ersteren (siehe Fig. 5) und in den drei Frequenzmultiplizierern 45, 47 und 49, falls vorhanden, der letzteren (siehe Fig. 7) gezählt werden. Die so erhaltenen Zählwerte stellen dann jeweils gewichtet und in digitaler Form die wirklichen und kalibrierten Werte der gemessenen Energie E dar.

Sobald der treppenförmig ansteigende Wert der Energie E in der Darstellung der Fig. 13 einen Schwellwert $E_L$ erreicht, d. h. wenn die Zählwerte der Frequenzmultiplizierer 45, 47 und 49 einen bestimmten vorgegebenen Grenzwert erreichen, wird am Ausgang des betreffenden Frequenzmultiplizierers 45, 47 oder 49 ein Übertrag-Impuls $E_o$ ausgelöst, unter gleichzeitiger Beibehaltung des Restwertes des Übertrags im betreffenden Frequenzmultiplizierer 45, 47 bzw. 49. In der Fig. 14 sind die Übertragimpulse $E_o$ eines der Frequenzmultiplizierer 45, 47 oder 49 dargestellt, welche im Laufe der Zeit t jedesmal dann am Ausgang des betreffenden Frequenzmultiplizierers 45, 47 oder 49 erscheinen, wenn der treppenförmig ansteigende Wert der Energie E den Schwellwert $E_L$ erreicht. Die Impulse $E_o$ besitzen einen Logik-wert 1 als Amplitude und eine Periode $T_o = 1/f_o$. Die vom Frequenzmultiplizierer 47 erzeugten Impulse $E_o$ werden spannungs- und/oder strommässig in der elektrischen Impuls-Ausgangsschaltung 48 an die elektrischen Randbedingungen des Fernzählausgangs 20 angepasst und erscheinen dort zeitlich nacheinander als elektrische Impulse. Die vom Frequenzmultiplizierer 49 erzeugten Impulse $E_o$ werden spannungs- und/oder strommässig in der optischen Impuls-Ausgangsschaltung 50 an die elektrischen Randbedingungen der Leuchtdiode 52 angepasst und erscheinen dort zeitlich nacheinander als Lichtimpulse. Die vom Frequenzmultiplizierer 45 erzeugten Impulse $E_o$ werden im Eingangs-zähler 46a der Anzeige 46 gezählt und der so erhaltene Zählwert anschliessend in der Digitalanzeige 46b angezeigt.

Bei der Kalibration des Elektrizitätszählers 1 geht es in erster Linie darum, den Wert des Kalibrationsfaktors $K_g$ bzw. $K_{g,j}$ zu ermitteln. Dies geschieht mit Hilfe einer Vergleichsreferenz, nämlich der Impulsfrequenz des Referenz-Elektrizitätszählers 2, welche die Frequenz der an dessem Impulsausgang 6 anstehenden Impulse ist und eine Referenzfrequenz $f_R$ bzw. $f_{R,j}$ darstellt. Die letztere erreicht vom Impulsausgang 6 des Referenz-Elektrizitätszählers 2 ausgehend über den Referenzsignal-Eingang 16 des Elektrizitätszählers 1, die Referenzeingang-Schnittstellenanordnung 8, den Referenzsignal-Eingang 17 der Einphasen-Messeinheit 7 (siehe Fig. 1) und den Referenzsignal-Eingang 29 der Gewichtungsfaktor-Ermittlungsanordnung 23 den Frequenzmultiplizierer 40 der letzteren (siehe Fig. 5), wo die Referenzfrequenz $f_R$ bzw. $f_{R,j}$ anschliessend mit einem Faktor $K_{MD}$ bzw. $K_{MD,j}$ multipliziert wird.

Zwei Arten von Kalibration sind möglich, nämlich eine Autokalibration oder eine rechnerunterstützte Kalibration.

Bei der Autokalibration wird die Kalibration des zu kalibrierenden Elektrizitätszählers 1 durch das externe Steuersignal ST, z. B. mittels der Betätigung des Schalters SW, freigegeben. Das externe Steuersignal ST hat dabei eine doppelte Funktion, nämlich einerseits den Start der Kalibration und anderseits eine Freigabe der Schreibsperre des Speichers 24 zu veranlassen. Sobald die Kalibration gestartet ist, gibt das Steuersignal ST das erste Freigabegatter 36 der Gewichtungsfaktor-Ermittlungsanordnung 23 kurzzeitig frei (siehe Fig. 5), so dass der anstehende oder, falls gerade keiner ansteht, der zeitlich nächste Ausgangsimpuls des Frequenzmultiplizierers 22 (siehe Fig. 2 oder Fig. 3) über das freigegebene Freigabegatter 36 den ersten Zähler 37 auf Null zurückstellt. Anschliessend zählt der letztere, vom Wert Null ausgehend, eine definierte Anzahl $n_S$ von Ausgangsimpulsen des Frequenzmultiplizierers 22, was einer bestimmten Zeit $n_S/f_S$ entspricht, wenn $f_S$ bzw. $f_{S,j}$ die Ausgangsfrequenz des Frequenzmultiplizierers 22 ist. Während dieser Zeit wird vom Ausgang des ersten Zählers 37 das zweite Freigabegatter 38 freigegeben, so dass während dieser Zeit die Ausgangsimpulse des Frequenzmultiplizierers 40 den zweiten Zähler 39 erreichen und dort zwecks Ermittlung ihrer Anzahl $n_G$ bzw. $n_{G,j}$ gezählt werden. Durch die Wahl des Wertes der Anzahl $n_S$ der Ausgangsimpulse des Frequenzmultiplizierers 22, d.h. durch die Wahl der Dauer $n_S/f_S$ bzw. $n_S/f_{S,j}$ des Freigabe-Zeitfensters für die Ausgangsimpulse des Frequenzmultiplizierers 40, wird der Wert des Kalibrationsfaktors $K_g$ bzw. $K_{g,j}$ beeinflusst. Zu diesem Zweck werden im voraus vorgegebene Werte der Zahl $n_S$ und des multiplikationsfaktors $K_{MD}$ bzw. $K_{MD,j}$ abrufbar im Speicher 24 des zu kalibrierenden Elektrizitätszählers 1 gespeichert.

Nachfolgend bezeichnet

- $Q_R$ bzw. $Q_{R,j}$ die Energie pro Referenzfrequenz-Impuls,
- $R_R = 1/Q_R$ bzw. $R_{R,j} = 1/Q_{R,j}$ die Anzahl Referenzfrequenz-Impulse pro Energieeinheit, z. B. pro kWh,
- $n_R$ bzw. $n_{R,j}$ die Anzahl der während der Dauer $n_S/f_S$ bzw. $n_S/f_{S,j}$ des Zeitfensters vorhandenen Referenzfrequenz-Impulse,
- $K_{MD} = M/D$ bzw. $K_{MD,j} = M/D$ der Frequenzmultiplikationsfaktor des Frequenzmultiplizierers 40,
- $Q_g$ die Energie pro Impuls eines idealen, d. h. kalibrierten Leistungs-Mess-Sensors 10;22,
- $R_S = 1/Q_S$ die Anzahl Impulse eines idealen, d. h. kalibrierten Leistungs-Mess-Sensors 10;22 pro Energieeinheit, z. B. pro kWh,

- $n_S$ der vorgegebene Zählwert des ersten Zählers 37,
- $n_G$ bzw. $n_{G,j}$ der während der Dauer $n_S/f_S$ bzw. $n_S/f_{S,j}$) des Zeitfensters gezählte Zählwert des zweiten Zählers 39,
- $Q_Z$ die Energie pro Impuls eines mit einer Zähleranpassung $K_A$ versehenen Elektrizitätszählers 1,
- $R_Z = 1/Q_Z$, auch Zählerkonstante genannt, die Anzahl der am Ausgang des kalibrierten Elektrizitätszählers 1 anstehenden Impulse pro gemessene Energieeinheit, z. B. pro gemessene kWh, wenn der kalibrierte Elektrizitätszähler 1 mit einer zähleranpassung $K_A$ versehen ist, und
- $K_A$ ein durch einen Ausgangsimpuls des kalibrierten Elektrizitätszählers 1 dargestelltes Energiequantum, wenn das durch einen Impuls der kalibrierten Frequenz $f_S$ bzw. $f_{S,j}$ dargestellte Energiequantum eine Energieeinheit, z. B. eine kWh, ist. Dabei ist die kalibrierte Frequenz $f_S$ bzw. $f_{S,j}$ z. B. die Ausgangsfrequenz des Frequenzmultiplizierers 22 (siehe Fig. 2 und Fig. 3).

Die während der Dauer $n_S/f_S$ bzw. $n_S/f_{S,j}$ des Zeitfensters vom Referenz-Elektrizitätszähler 2 gemessene Energie ist:

$$E_R - Q_R . n_R = (1/R_R) . n_R \text{ bzw. } E_{R,j} = Q_{R,j} . n_{R,j} = (1/R_{R,j}) . n_{R,j} \tag{2}$$

Weiter folgt, mit

$$n_R = (1/K_{MD}) . n_G \text{ bzw. } n_{R,j} = (1/K_{MD,j}) . n_{G,j} \tag{3}$$

eingesetzt in der Gleichung (2):

$$E_R = (1/R_R) . (1/K_{MD}) . n_G \text{ bzw. } E_{R,j} = (1/R_{R,j}) \cdot (1/K_{MD,j}) . n_{G,j} \tag{4}$$

Die während der Dauer $n_S/f_S$ bzw. $n_S/f_{S,j}$ des Zeitfensters von einem idealen, d. h. kalibrierten Leistungs-Mess-Sensor 10;22 gemessene Energie $E_S$ ist:

$$E_S = Q_S . n_S = (1/R_S) . n_S \tag{5}$$

Ein unkalibrierter Leistungs-Mess-Sensor 10 misst eine Energiemenge $E_{SU}$ bzw. $E_{SU,j}$, die sich um den Kalibrierungsfaktor $K_g$ bzw. $K_{g,j}$ vom Energie-Messwert $E_S$ des idealen kalibrierten Leistungs-Mess-Sensors 10;22 unterscheidet, d. h.:

$$E_{SU} = K_g . E_S \text{ bzw. } E_{SU,j} = K_{g,j} . E_S \tag{6}$$

Da wegen der externen Beschaltung der beiden Elektrizitätszähler 1 und 2 diese eine gleiche Energie messen, gilt:

$$E_{SU} = E_R \text{ bzw. } E_{SU,j} = E_{R,j} \tag{7}$$

oder

$$K_g . E_S = E_R \text{ bzw. } K_{g,j} . E_S = E_{R,j} \tag{8}$$

Nach Einsetzen der Gleichungen (4) und (5) in die Gleichung (8) ergibt sich der Kalibrationsfaktor $K_g$ bz. $K_{g,j}$ zu:

$$K_g = E_R/E_S = [(1/R_R) . (1/K_{MD}) . n_G]/[(1/R_S) . n_S] \text{ bzw.}$$

$$K_{g,j} = E_{R,j}/E_S = [(1/R_{R,j}) . (1/K_{MD,j}) . n_{G,j}]/[(1/R_S) . n_S] \tag{9}$$

Um diese komplexe Rechnung zu vermeiden, wird

$$K_g = n_G \qquad \text{bzw. } K_{g,j} = n_{G,j} \qquad\qquad (10)$$

gewählt, d. h. es müssen

$$[(1/R_R).(1/K_{MD})]/[(1/R_S).n_S] = 1 \text{ bzw.}$$

$$[(1/R_{R,j}).(1/K_{MD,j})]/[(1/R_S).n_S] = 1 \text{ oder}$$

$$K_{MD} = (R_S/R_R).(1/n_S) \text{ bzw.}$$

$$K_{MD,j} = (R_S/R_{R,j}).(1/n_S) \qquad\qquad (11)$$

gewählt werden.

Soll die Berechnung aufgrund einer geforderten Zählerkonstante $R_Z$ des Elektrizitätszählers 1 erfolgen, dann gilt bei einer gegebenen Zähleranpassung $K_A$:

$$Q_Z = Q_S. K_A \qquad\qquad (12)$$

oder

$$R_S = R_Z.K_A \qquad\qquad (13),$$

was, in der Gleichung (11) eingesetzt, für den Frequenzmultiplikationsfaktor $K_{MD}$ bzw. $K_{MD,j}$ des Frequenzmultiplizierers 40 den Wert

$$K_{MD} = (R_Z/R_R).(K_A/n_S) \text{ bzw. } K_{MD,j} = (R_Z/R_{R,j}).(K_A/n_S) \qquad\qquad (14)$$

ergibt.

Der im zweiten Zähler 39 ermittelte Zählwert $n_G$ bzw. $n_{G,j}$ ist somit gemäss Gleichung (10) gleich dem gesuchten Wert des Kalibrationsfaktors $K_g$ bzw. $K_{g,j}$, wenn die in der Gleichung (11) bzw. (14) ausgedrückte Bedingung durch den gewählten vorgegebenen Wert des Frequenzmultiplikationsfaktors $K_{MD}$ bzw. $K_{MD,j}$ des Frequenzmultiplizierers 40 erfüllt ist. Der Zählwert $n_G$ bzw. $n_{G,j}$ wird zur weiteren Verwendung als Wert $K_g$ bzw. $K_{g,j}$ über die erste Busverbindung 30 in den Speicher 24 unverlierbar abgespeichert, wo er jederzeit abgerufen und über die zweite Busverbindung 31 übertragen werden kann zur weiteren Verwendung im Frequenzmultiplizierer 22 (siehe Fig. 2 und Fig. 3).

Wie bereits erwähnt wird das erfindungsgemässe Verfahren und/oder die erfindungsgemässe Anordnung am vorteilhaftesten in Mehrphasen-Elektrizitätszählern oder in Mehrphasen-Kombinations-Elektrizitätszählern verwendet, die eine oder mehrere Energiearten, wie z. B. Wirk- und Blindenergie, messen. In diesen Fällen ist jeweils im zu kalibrierenden Elektrizitätszähler eine Einphasen-Messeinheit 7 pro Phase des Mehrphasen-Elektrizitätszählers bzw. pro Phase einer jeden im Mehrphasen-Kombinations-Elektrizitätszähler gemessenen Energieart, wie z. B. der Wirk- und Blindenergie, enthalten. Ausserdem ist pro Mehrphasen-Elektrizitätszähler jeweils eine Additionsschaltung 59 und eine Messwert-Ausgabeeinheit 9 vorhanden.

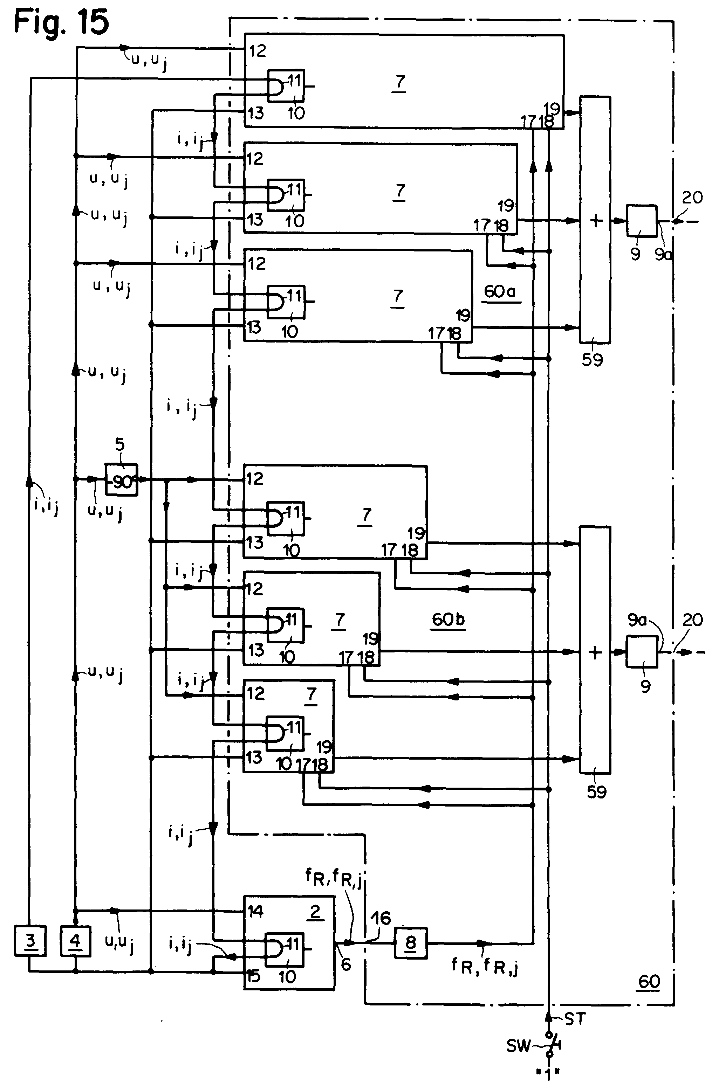

In der Fig. 15 gilt die Annahme, dass der zu kalibrierende Elektrizitätszähler 1 ein Mehrphasen-Kombinations-Elektrizitätszähler 60 ist, der einen Wirkenergie-Dreiphasen-Elektrizitätszähler 60a und einen Blindenergie-Dreiphasen-Elektrizitätszähler 60b sowie eine einzige gemeinsame Referenzeingang-Schnittstellenanordnung 8 enthält. Im Wirkenergie-Dreiphasen-Elektrizitätszähler 60a ist eine jede pro Phase vorhandene Einphasen-Messeinheit 7 eine solche, wie sie in der Fig. 2 dargestellt ist, während eine jede im Blindenergie-Dreiphasen-Elektrizitätszähler 60b pro Phase vorhandene Einphasen-Messeinheit 7 eine solche ist, wie sie in der Fig. 3 dargestellt ist.

In der in der Fig. 15 dargestellten Kalibrationsanordnung ist ausser dem zu kalibrierenden Mehrphasen-Kombinations-Elektrizitätszähler 60 noch die Stromquelle 3, die Spannungsquelle 4, der Phasenschieber 5 und der Referenz-Elektrizitätszähler 2 vorhanden. Um den Geräteaufwand möglichst niedrig zu halten, sind trotz der Mehrphasigkeit der Elektrizitätszähler 60a und 60b nur eine einphasige Stromquelle 3 und nur eine einphasige Spannungsquelle 4 vorhanden. Aus dem gleichen Grund wird als Referenz-Elektrizitätszähler 2 vorzugsweise ein einphasiger Elektrizitätszähler verwendet, nämlich z. B. ein Wirkenergie-Elektrizitätszähler. Natürlich ist es auch möglich, eine Mehrphasen-Stromquelle 3 und eine Mehrphasen-Spannungsquelle 4 zu verwenden, wenn die Streuungen zwischen den Strömen und den Spannungen der einzelnen Phasen der Mehrphasen-Speisequellen 3 und 4 sowohl in Phase als auch in Betrag den Genauigkeitsanforderungen genügen. Die Stromquelle 3 speist in der Darstellung der Fig. 15 die elektrisch in Reihe geschalteten U-förmigen Stromschlaufen 11 aller Einphasen-Messeinheiten 7 und des Referenz-Elektrizitätszählers 2 mit dem gleichen Strom i bzw. $i_j$. Die gleiche Spannung u bzw. $u_j$ der Spannungsquelle 4 speist ihrerseits über den Phasenschieber 5 parallel die zweipoligen Spannungseingänge 12;13 aller Einphasen-Messeinheiten 7 des Blindenergie-Dreiphasen-Elektrizitätszählers 60b, sowie unmittelbar und ebenfalls parallel die zweipoligen Spannungseingänge 12;13 aller Einphasen-Messeinheiten 7 des Wirkenergie-Dreiphasen-Elektrizitätszählers 60a und den zweipoligen Spannungseingang 14;15 des Referenz-Elektrizitätszählers 2. Dadurch messen alle Leistungs-Mess-Sensoren 10 der beiden Elektrizitätszähler 60 und 2 eine gleiche Leistung u.i bzw. $u_j.i_j$. Je ein Pol der Stromquelle 3 und der Spannungsquelle 4, der Pol 15 des zweipoligen Spannungseingangs 14;15 des Referenz-Elektrizitätszählers 2 sowie sämtliche Pole 13 der zweipoligen Spannungseingänge 12;13 aller Einphasen-Messeinheiten 7 des Mehrphasen-Kombinations-Elektrizitätszählers 60 sind elektrisch miteinander verbunden und liegen an einem gemeinsamen Bezugspotential. Der Impulsausgang 6 des Referenz-Elektrizitätszählers 2 ist auf den Referenzsignal-Eingang 16 des Mehrphasen-Kombinations-Elektrizitätszählers 60 geführt, welcher Eingang intern im letzteren über die einzige Referenzeingang-Schnittstellenanordnung 8 mit den Referenzsignal-Eingängen 17 aller Einphasen-Messeinheiten 7 verbunden ist. Der Impulsausgang 6 des Referenz-Elektrizitätszählers 2 ist somit nur mit einem einzigen Referenzsignal-Eingang 16 des Elektrizitätszählers 60 belastet. Das externe Steuersignal ST speist die Steuereingänge 18 aller Einphasen-Messeinheiten 7, indem bei der Autokalibration z. B. ein Schalter SW im Startaugenblick einen Logikwert "1" auf die Steuereingänge 18 aller Einphasen-Messeinheiten 7 schaltet. Die Frequenzausgänge 19 der drei Einphasen-Messeinheiten 7 des Wirkenergie-Dreiphasen-Elektrizitätszählers 60a sind mit je einem von drei Eingängen einer ersten von zwei Additionsschaltungen 59 verbunden, deren Ausgang auf einen Eingang einer ersten von zwei Messwert-Ausgabeeinheiten 9 geführt ist, deren Ausgang 9a seinerseits fakultativ mit einem ersten von zwei Fernzählausgängen 20 des Mehrphasen-Kombinations-Elektrizitätszählers 60 verbunden ist. Die Frequenzausgänge 19 der drei Einphasen-Messeinheiten 7 des Blindenergie-Dreiphasen-Elektrizitätszählers 60b sind dagegen mit je einem von drei Eingängen einer zweiten der zwei Additionsschaltungen 59 verbunden, deren Ausgang auf einen Eingang einer zweiten der beiden Messwert-Ausgabeeinheiten 9 geführt ist, deren Ausgang 9a seinerseits wieder fakultativ mit einem zweiten der zwei Fernzählausgänge 20 des Mehrphasen-Kombinations-Elektrizitätszählers 60 verbunden ist. Dabei wird jede Einphasen-Messeinheit 7 unabhängig von allen anderen Einphasen-Messeinheiten 7 abgeglichen, d. h. kalibriert. Da alle Kombinations-Elektrizitätszähler mindestens zwei unterschiedliche Mess-Systeme besitzen, nämlich z. B. eines zur Messung der Wirkenergie und eines zur Messung der Blindenergie, sind diese bei der Kalibration auch unterschiedlich zu behandeln durch Verwendung bzw. nicht Verwendung des Phasenschiebers 5. Die Kalibrationsoperation kann dabei für den Wirkenergie- und den Blindenergie-Teil des Kombinations-Elektrizitätszählers jeweils getrennt durchgeführt werden nach Ab- oder Zuschalten des Phasenschiebers 5 oder es können, wie in der Fig. 15 dargestellt, auch alle sechs Einphasen-Messeinheiten 7 des Kombinations-Elektrizitätszählers 60 gleichzeitig kalibriert werden.

Ein jeder in dem zu kalibrierenden Elektrizitätszähler 1 bzw. 60 pro Einphasen-Messeinheit 7 vorhandener Multiplikationsfaktor wird zuerst nur grob mittels des zugehörigen Vorwiderstandes 21 auf einen optimalen Arbeitspunkt eingestellt, was fertigungstechnisch einfach realisierbar ist. Durch eine sehr einfache Zusammenschaltung (siehe Fig. 1 und Fig. 15) des zu kalibrierenden Elektrizitätszählers 1 bzw. 60 mit der Stromquelle 3, der Spannungsquelle 4, dem Referenz-Elektrizitätszähler 2 und gegebenenfalls dem Phasenschieber 5 werden die Ausgangsimpulse des Leistungs-Mess-Sensors 10 des Referenz-Elektrizitätszählers 2 (siehe Fig. 4) über die Schnittstellenanordnungen 35 und 8 auf den Referenzsignal-Eingang 17 einer jeden Einphasen-Messeinheit 7 des zu kalibrierenden Elektrizitätszählers 1 bzw. 60 geführt. Der letztere bestimmt dann selbständig für jede Phase eine Korrekturgrösse, d. h. einen Wert $n_G$ bzw. $n_{G,j}$ des Kalibrationsfaktors $K_g$ bzw. $K_{g,j}$ für die intern in der zugehörigen Einphasen-Messeinheit 7 des zu kalibrierenden Elektrizitätszähler 1 bzw. 60 erzeugten Energieimpulse und speichert die ermittelten Werte $n_G$ bzw. $n_{G,j}$ der Kalibrationsfaktoren $K_g$ bzw. $K_{g,j}$ im Speicher 24.

Im Falle einer Software-Lösung des Kalibrationsverfahrens wird die am Impulsausgang 6 des Referenz-Elektrizitätszählers 2 erscheinende Referenzfrequenz $f_R$ bzw. $f_{R,j}$ vom zu kalibrierenden Elektrizitätszähler 1 bzw. 60 z. B. mittels einer Interrupt-Routine oder eines Ereigniszählers eines im Elektrizitätszähler 1 bzw. 60 enthaltenen Mikrocomputers 74 erfasst zwecks Ermittlung der Werte der Kalibrationsfaktoren $K_g$ bzw. $K_{g,j}$. Die Gewichtungsfaktor-Ermittlungsanordnung 23 ist dann nicht mehr vorhanden und der Mikrocomputer verwirklicht selber die Funktion der letzteren, indem er die ihm zugeführte Referenzfrequenz $f_R$ bzw. $f_{R,j}$ mit dem Faktor $K_{MD}$ bzw. $K_{MD,j}$ multipliziert sowie die ihm zugeführten Impulse der Ausgangsfrequenz $f_S$ bzw. $f_{S,j}$ des Frequenzmultiplizierers 22 zählt und den Zählwert $n_S$ verwendet zur Freigabe der Zählung der Impulse der mit dem Faktor $K_{MD}$ bzw. $K_{MD,j}$ multiplizierten Referenzfrequenz $f_R$ bzw. $f_{R,j}$ zwecks Ermittlung des Zählwertes $n_G$ bzw. $n_{G,j}$, welcher anschliessend im Speicher 24 des Mikrokomputers abgespeichert wird, um schliesslich über die zweite Busverbindung 31 dem Multiplizierer 22 zugeführt zu werden.

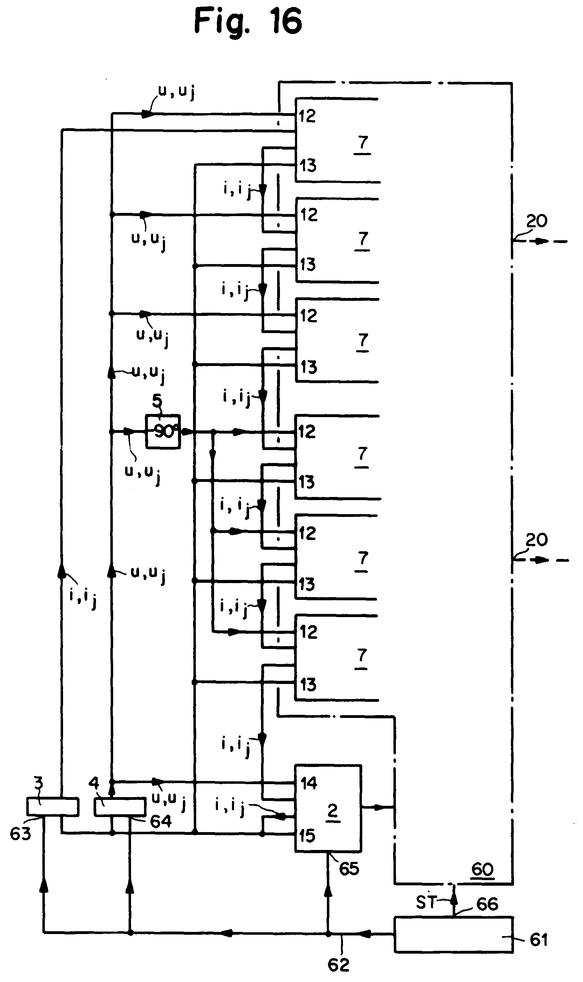

In der Fig. 16 ist eine Anordnung zur rechnerunterstützten Kalibration eines Mehrphasen-Kombinations-Elektrizitätszählers 60 dargestellt. Die rechnerunterstützte Kalibration unterscheidet sich von der Autokalibration nur dadurch, dass der Schalter SW jeweils durch einen Kalibrationscomputer 61 ersetzt ist, dessen Steuerausgang über eine Steuerbusverbindung 62 mit je einem Steuereingang 63 der Stromquelle 3, 64 der Spannungsquelle 4 und 65 des Referenz-Elektrizitätszählers 2 verbunden ist zwecks Start und Steuerung des zeitlichen Ablaufs der Kalibration. Der Kalibrationscomputer 61 erzeugt einerseits im Startaugenblick das externe Steuersignals ST, welches auf den Steuereingang 18 der Einphasen-Messeinheiten 7 geführt ist, und schaltet anderseits über die Steuerbusverbindung 62 die Stromquelle 3, die Spannungsquelle 4 und den Referenz-Elektrizitätszähler 2 ein und aus, wobei diese über die Steuereingänge 63, 64 und 65 für eine bestimmte Zeit eingeschaltet werden. Ausserdem erscheint an einem gemäss dem EIA Standard normierten RS 232-Schnittstellenausgang 66 des Kalibrationscomputers 61 das Steuersignal ST, welches über einen Eingang des zu kalibrierenden Elektrizitätszählers 1 bzw. 60 wieder die Steuereingänge 18 aller Einphasen-Messeinheiten 7 speist. Ansonsten funktioniert die rechnerunterstützte Kalibration genau gleich wie die Autokalibration. Unter anderem zählt der Elektrizitätszähler 1 bzw. 60 intern die Impulse der Ausgangsfrequenzen $f_S$ bzw. $f_{S,j}$ aller vorhandenem Frequenzmultiplizierer 22 bis zum Erreichen des Zählwertes $n_S$. Zusätzlich werden noch die Impulse der mit dem Faktor $K_{MD}$ bzw. $K_{MD,j}$ multiplizierten Referenzfrequenz $f_R$ bzw. $f_{R,j}$ während der Dauer $n_S/f_S$ bzw. $n_S/f_{S,j}$ des Freigabe-Zeitfensters gezählt zwecks Ermittlung der Zählwerte $n_G$ bzw. $n_{G,j}$, was entweder intern im Elektrizitätszähler 1 bzw. 60 oder extern durch einen fremden Ereigniszähler erfolgen kann. Nach Ablauf der Dauer $n_S/f_S$ bzw. $n_S/f_{S,j}$ des Freigabe-Zeitfensters werden die Zählwerte $n_G$ bzw. $n_{G,j}$ gelesen und daraus die Werte des Kalibrationsfaktors $K_g$ bzw. $K_{g,j}$ abgeleitet, welche dann im Speicher 24 des Elektrizitätszählers 1 bzw. 60 gespeichert werden.

Eine Simultankalibrierung mehrerer unkalibrierter Elektrizitätszähler 1 bzw. 60, die je einen Referenzsignal-Eingang 16 aufweisen, ist auch möglich, indem anstelle eines einzigen unkalibrierten Elektrizitätszählers alle unkalibrierten Elektrizitätszähler sowie der Referenz-Elektrizitätszähler 2 strommässig seriell an die Stromquelle 3 und spannungsmässig parallel an die Spannungsquelle 4 angeschlossen werden. Die Ausgangsimpulse des Referenz-Elektrizitätszählers 2 werden dann vorzugsweise über einen Verteilverstärker den Referenzsignal-Eingängen 16 der einzelnen zu kalibrierenden Elektrizitätszähler zugeführt. Sind weniger als vier Elektrizitätszähler zu kalibrieren, dann kann der Impulsausgang 6 des Referenz-Elektrizitätszählers 2 auch mit der Reihenschaltung der dann zweipoligen Referenzsignal-Eingänge 16 der zu kalibrierenden Elektrizitätszähler verbunden werden, indem die Leuchtdioden 57 der Referenzeingang-Schnittstellenanordnungen 8 (siehe Fig. 9) der Elektrizitätszähler elektrisch in Reihe geschaltet werden, was bedingt, das in drei der vier Elektrizitätszähler kein Pol der zugehörigen Leuchtdiode 57 an Masse liegt.

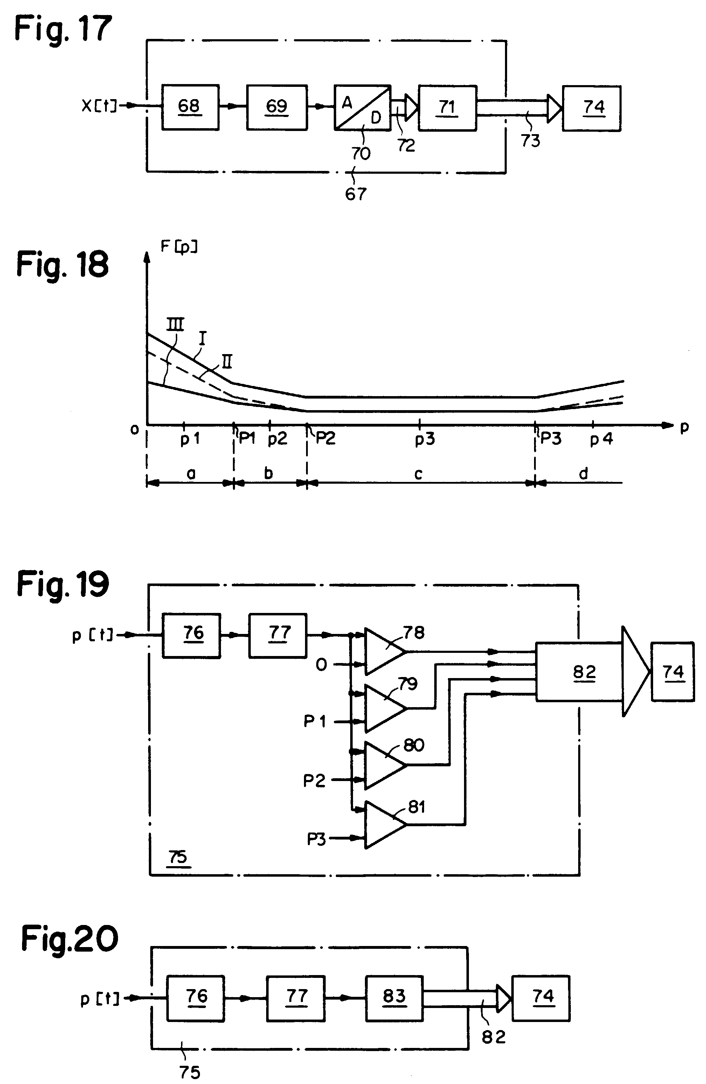

Der anlässlich der Kalibration im Kalibrationsaugenblick, z. B. vor der Lagerung oder vor der ersten Inbetriebnahme der Elektrizitätszähler 1 bzw. 60, gemäss Gleichung (10) ermittelte Wert des Kalibrationsfaktors $K_g = n_G$ bzw. $K_{g,j} = n_{G,j}$ berücksichtigt nur die im Kalibrationsaugenblick geltenden Arbeits-Randbedingungen der Elektrizitätszähler 1 bzw. 60. Die so gefundenen Werte des Kalibrationsfaktors $K_g$ bzw. $K_{g,j}$ sind nur dann konstant und während des Betriebs der Elektrizitätszähler 1 bzw. 60 gültig, wenn diese Arbeits-Randbedingungen auch während des Betriebs erhalten und konstant bleiben, was selten der Fall ist. Daher werden in einer bevorzugten Ausführung der erfindungsgemässen Anordnung die anlässlich der Kalibration gefundenen Werte des Kalibrationsfaktors $K_g$ bzw. $K_{g,j}$ während des Betriebs fortlaufend den sich möglicherweise ändernden Arbeits-Randbedingungen der Elektrizitätszähler 1 bzw. 60 angepasst. Zu diesem Zweck werden Parameter x[t], die diese Arbeits-Randbedingungen beeinflussen, im Betrieb fortlaufend gemessen und die so gefundenen Messwerte in den Wert eines multiplikativen Korrekturfaktors $K_x$ umgewandelt, d. h. der Kalibrationsfaktor $K_g$ bzw. $K_{g,j}$ wird durch einen im Augenblick geltenden neuen Kalibrations- und Korrekturfaktor $K_{gg} = K_g . K_x$ bzw. $K_{gg,j} = K_{g,j} . K_x$ ersetzt zwecks Kompensation des Einflusses der zeitabhängigen Parameter x[t]. Zu diesem Zweck ist in den Elektrizitätszählern 1 bzw. 60 für jeden Parameter x[t], dessen Einfluss zu kompensieren ist, eine Parameter-Messanordnung 67 enthalten, die vorzugsweise den in der Fig. 17 dargestellten Aufbau besitzt. Die Parameter-Messanordnung 67 enthält, in der angegebenen Reihenfolge in einer Kettenschaltung hintereinander geschaltet, einen Parameter-Mess-Sensor 68 zur fortlaufenden Messung des Augenblickswertes des zugehörigen Parameters x[t], eine Abtast- und Halte-Schaltung ("sample and hold circuit") 69 zur periodischen Abtastung und Speicherung der gemessenen Werte des zugehörigen Parameters x[t], einen Analog/Digital-Wandler 70 zur Umwandlung der so erhaltenen diskreten analogen Abtastwerte in diskrete Digitalwerte und einen Codierer 71 zur Umcodierung der diskreten Digitalwerte in einen zugehörigen Wert des Korrekturfaktors $K_x$. Der Codierer 71 ist vorzugsweise ein ROM-Festwertspeicher ("Read only memory"), dessen Adressen-Eingänge über eine Busverbindung 72 mit dem Digitalausgang des Analog/Digital-Wandlers 70 verbunden sind und in dessen Speicherzellen für jeden Digitalwert der diskreten Abtastwerte ein zugehöriger Wert des Korrekturfaktors $K_x$ gespeichert ist. Der zum gerade ermittelten Abtastwert gehörende Wert des Korrekturfaktors $K_x$ wird dann über eine weitere Busverbindung 73 einem im Elektrizitätszähler 1 bzw. 60 vorhandenen Mikrocomputer 74 zugeleitet, der schliesslich den Wert des Kalibrations- und Korrekturfaktors $K_{gg} = K_g . K_X$ bzw. $K_{gg,j} = K_X$ berechnet, um dessen neuen Wert dann dem Multiplizierer 22 zuzuleiten, mit oder ohne vorhergehende Zwischenspeicherung im Speicher 24 (siehe Fig. 2 und Fig. 3).

Der Parameter x[t] ist z. B. eine Temperatur T[t]. Ist der Temperatureinfluss im Elektrizitätszähler 1 bzw. 60 bekannt und in Gestalt eines Temperatureinfluss-Faktors $1/K_T$ mathematisch beschreibbar, so kann der Einfluss der Temperatur durch ein multiplikatives Aufschalten der inversen Funktion in Gestalt des Temperatureinfluss-Korrekturfaktors $K_T$ kompensiert werden. In diesem Fall ist $K_X = K_T$.

Der Parameter x[t] kann aber auch die Netzfrequenz f[t] eines die Elektrizitätszähler 1 bzw. 60 im Betrieb speisenden Netzstromes sein, wenn z. B. der vom Phasenschieber 5 und/oder 33 erzeugte Phasenwert von 90° frequenzabhängig ist. Ist diese Frequenzabhängigkeit in Gestalt eines Frequenzabhängigkeits-Faktors $1/K_f$ mathematisch beschreibbar, so lässt sich der Fehler wieder durch ein multiplikatives Aufschalten der inversen Funktion in Gestalt des Frequenzeinfluss-Korrekturfaktors $K_f$ kompensieren. In diesem Fall ist $K_X = K_f$.

Wenn dem Elektrizitätszähler 1 bzw. 60 Spannungswandler und/oder Stromwandler vorgeschaltet sind, die mit bekannten, jedoch zeit-und/oder temperaturabhängigen Fehlern behaftet sind, so kann auch der Einfluss dieser Fehler kompensiert werden, wenn die Fehler in Gestalt eines Wandlerfehler-Faktors $1/K_W$ mathematisch beschreibbar sind, durch ein multiplikatives Aufschalten der inversen Funktion in Gestalt des Wandlerfehlereinfluss-Korrekturfaktors $K_W$. In diesem Fall ist $K_x = K_W$.

Soll sowohl der Einfluss der Temperatur T[t] als auch derjenige der Netzfrequenz f[t] und der Wandlerfehler kompensiert werden, dann ist $K_x = K_T.K_f.K_W$ zu wählen, wobei die geltenden Werte $K_T$, $K_f$ und $K_W$ getrennt voneinander im Elektrizitätszähler 1 bzw. 60 ermittelt werden. In diesem Fall ist in den zu kalibrierenden Elektrizitätszählern 1 bzw. 60 je eine Parameter-Messanordnung 67 pro vorhandenen Parametereinfluss-Korrekturfaktor $K_T$, $K_f$ und $K_W$ enthalten zur Ermittlung der Werte des betreffenden Parametereinfluss-Korrekturfaktors $K_T$, $K_f$ oder $K_W$. Diese Werte werden anschliessend über die Busverbindung 73 dem in den zu kalibrierenden Elektrizitätszählern 1 bzw. 60 enthaltenen Mikrocomputer 74 zugeführt zwecks Berechnung der Werte des Kalibrations- und Korrekturfaktors $K_{gg}$ bzw. $K_{gg,j}$.

Es gilt dann:

$$K_{gg} = K_T.K_f.K_W.K_g \text{ bzw.}$$

$$K_{gg,j} = K_T.K_f.K_W.K_{g,j}$$

Im Betrieb ist der Korrekturfaktor $K_x$ somit ein Produkt von Parametereinfluss-Korrekturfaktoren $K_T$, $K_f$ und $K_W$, wobei einer oder mehrerer der Parametereinfluss-Korrekturfaktoren $K_T$, $K_f$ und $K_W$ einen Wert Eins besitzen kann. $K_x$ ist dabei z. B. das Produkt des Temperatureinfluss-Korrekturfaktors $K_T$ und/oder des Frequenzeinfluss-Korrekturfaktors $K_f$ und/oder des Wandlerfehlereinfluss-Korrekturfaktors $K_W$. Dem Frequenzmultiplizierer 22 wird im Betrieb bei jeder Messung der Energie der berechnete Wert des zugehörigen Kalibrations- und Korrekturfaktors $K_{gg} = K_x.K_g$ bzw. $K_{gg,j} = K_x.K_{g,j}$ zugeführt zwecks Multiplikation der Impulsfrequenz $f_E$ bzw. $f_{E,j}$ seines Eingangssignals mit dem zugeführten Wert des Kalibrations- und Korrekturfaktors $K_{gg}$ bzw. $K_{gg,j}$.

Wenn einer der Parametereinfluss-Korrekturfaktoren ein Temperatureinfluss-Korrekturfaktor $K_T$ ist, dann ist der letztere vorzugsweise eine inverse Funktion des Temperaturabhängigkeits-Faktors $1/K_T$, mit dem die Temperatur die Messresultate der zu kalibrierenden Elektrizitätszähler 1 bzw. 60 beeinflusst.

Wenn einer der Parametereinfluss-Korrekturfaktoren ein Frequenzeinfluss-Faktor $K_f$ ist, dann ist der letztere vorzugsweise eine inverse Funktion des Frequenzabhängigkeits-Faktors $1/K_f$, mit dem die Frequenz die Messresultate der zu kalibrierenden Elektrizitätszähler 1 bzw. 60 beeinflusst.

Wenn einer der Parametereinfluss-Korrekturfaktoren ein Wandlerfehlereinfluss-Faktor $K_w$ ist, dann ist der letztere vorzugsweise eine inverse Funktion des Wandlerfehlerabhängigkeits-Faktors $1/K_w$, mit dem die Fehler von Wandlern, die den zu kalibrierenden Elektrizitätszählern 1 bzw. 60 vorgeschaltet sind, die Messresultate der letzteren beeinflussen.

Im Kalibrations-Augenblick werden für die Korrekturfaktoren $K_x$, $K_T$, $K_f$ und $K_w$ vorzugsweise je ein Wert Eins gewählt.

Ein Vergleich mit der Gleichung (1) ergibt für die gemessene Energie E somit schliesslich den Wert:

$$E = \Sigma\ K_{gg} \text{ bzw. } E = \Sigma\ K_{gg,j}$$

Die Fehlerkennlinie F[p] eines Elektrizitätszählers 1 bzw. 60 in Funktion der Leistung p ist nicht über den gesamten Messbereich der Leistung p konstant, sondern besitzt z. B. den in Fig. 18 dargestellten badewannenförmigen Verlauf und ist unkorrigiert durch die Kennlinie I dargestellt. Die letztere besitzt zum Beispiel vier Leistungsbereiche a, b, c und d mit unterschiedlichen Fehlerverläufen in Funktion der Leistung p. Der Leistungsbereich a besitzt z. B. die Leistungs-Grenzwerte 0 und P1, der Leistungsbereich b die Leistungs-Grenzwerte P1 und P2, der Leistungsbereich c die Leistungs-Grenzwerte P2 und P3 und der Leistungsbereich d die Leistungs-Grenzwerte P3 und theoretisch unendlich. Ideal wäre ein horizontaler Verlauf der Fehlerkennlinie F[p], wie er im Leistungsbereich c dargestellt ist. Durch die bisher beschriebenen Kalibrations- und Korrekturmassnahmen wird die Kennlinie I parallel in Richtung niedrigere Werte von F[p] verschoben zwecks Erzeugung einer korrigierten Fehlerkennlinie II, deren horizontaler Teil im Leistungsbereich c mit dem horizontalen Teil einer korrigierten Kennlinie III übereinstimmt. Ausserhalb des Leistungsbereichs c ist der durch den gestrichelten Teil der Kennlinie II dargestellte Fehler trotz der erwähnten Kalibrations- und Korrekturmassnahmen immer noch zu gross, da der Kennlinienverlauf der Kennlinie II in den Leistungsbereichen a, b und d immer noch relativ steil und weit von einer horizontalen Kennlinie entfernt ist. Um dies zu verbessern und eine korrigierte Fehlerkennlinie III zu erhalten, muss in den Leistungsbereichen a, b und d ein anderer Wert des Kalibrationsfaktors $K_g$ gewählt werden als im Leistungsbereich c, d. h. für jeden Leistungsbereich a, b, c und d ist im Kalibrationsaugenblick ein anderer Wert $K_{g,j}$ des Kalibrationsfaktors zu wählen mit j = 1, 2, 3 oder 4, wenn j eine laufende Nummer der fortlaufend durchnumerierten Leistungsbereiche a, b, c und d darstellt. $K_{g,j}$ stellt dann den im Leistungsbereich j geltenden Wert des Kalibrationsfaktors dar.

Zu diesem Zweck wird der Leistungsmessbereich eines jeden zu kalibrierenden Elektrizitätszählers 1 bzw. 60 in einem oder mehreren Leistungsbereichen unterteilt. Im ersteren Fall ist der einzige Leistungsbereich entweder gleich dem gesamten Leistungsmessbereich, dann messen die Elektrizitätszähler 2 und 1 bzw. 2 und 60 je einen Leistungswert p = u.i, oder gleich einem der Leistungsbereiche a, b, c oder d, z. B. gleich dem Leistungsbereich c , dann messen die Elektrizitätszähler 2 und 1 bzw. 2 und 60 je einen Leistungswert $p_j = u_j.i_j$ mit j = 3. Wenn dagegen in mehreren Leistungsbereichen a, b, c und d getrennt kalibriert wird, dann messen die Elektrizitätszähler 2 und 1 bzw. 2 und 60 je einen Leistungswert $p_j = u_j.i_j$ mit j = 1, 2, 3 oder 4.

In jedem Leistungsbereich in dem getrennt kalibriert wird, d. h. im Gesamtleistungsmessbereich bzw. im Leistungsbereich c bzw. in jedem der Leistungsbereiche a, b, c und d, wird ein Leistungswert p = u.i bzw. $p_j = u_j.i_j$ gewählt und über die Stromeingänge, d. h. über die Stromschlaufen 11, und über die Spannungseingänge 12;13 bzw. 14;15 der zu kalibrierenden Elektrizitätszähler 1 bzw. 60 und des Referenz-Elektrizitätszählers 2 mit Hilfe des Eingangsstromes i bzw. $i_j$ und der Eingangsspannung u bzw. $u_j$ den Elektrizitätszählern 2 und 1 bzw. 2 und 60 eine Leistung zugeführt, deren Wert gleich dem gewählten Leistungswert p bzw. $p_j$ ist. Der Referenz-Elektrizitätszähler 2 und die Einphasen-Messeinheiten 7 messen in diesem Fall einen gleichen Leistungswert u.i bzw. $u_j.i_j$ einer gleichen Energieart, z. B. einer Wirkenergie. Die Einphasen-Messeinheiten 7 und der Referenz-Elektrizitätszähler 2 weisen dann je eine Impulsfrequenz $f_E$ bzw. $f_R$ oder $f_{E,j}$ bzw. $f_{R,j}$ auf, die jeweils proportional der in der betreffenden Einphasen-Messeinheit 7 bzw. im Referenz-Elektrizitätszähler 2 gemessenen Leistung p bzw. $p_j$ ist. Dabei ist die Impulsfrequenz des Referenz-Elektrizitätszählers 2, d. h. die Frequenz der an dessem Impulsausgang 6 anstehenden Impulse, die Referenzfrequenz $f_R$ bzw. $f_{R,j}$. Für jeden gewählten Leistungswert p bzw. $p_j$, d. h. in jedem zu kalibrierenden Leistungsbereich a, b, c und/ oder d, ist dann in jeder Einphasen-Messeinheit 7 eine Impulsfrequenz $f_E$ bzw. $f_{E,j}$ vorhanden, die proportional der durch die betreffende Einphasen-Messeinheit 7 gemessenen Leistung p bzw. $p_j$ ist und die anschliessend mit dem Kalibrations- und Korrekturfaktor $K_{gg}$ bzw. $K_{gg,j}$ multipliziert wird zwecks Erzeugung der Frequenz $f_S$ bzw. $f_{S,j}$. Neben den vorgegebenen Werten der Zahl $n_S$ werden dabei auch die Werte eines jeden Frequenzmultiplikationsfaktors $K_{MD}$ = $[R_Z/R_R].[K_A/n_S]$ bzw. $K_{MD,j} = [R_Z/R_{R,j}].[K_A/n_S]$ abrufbar im Speicher 24 der zu kalibrierenden Elektrizitätszähler 1 bzw. 60 gespeichert. Dabei ist $R_R$ bzw. $R_{R,j}$ die Anzahl Impulse pro Energieeinheit der am Impulsausgang 6 des Referenz-Elektrizitätszählers 2 anstehenden Impulse, wenn dieser die Leistung p bzw. $p_j$ misst. $R_z$ stellt wieder die Anzahl Impulse pro Energieeinheit des mit der Zähleranpassung $K_A$ versehenen Elektrizitätszählers 1 bzw. 60 dar. Die Referenzfrequenz $f_R$ bzw. $f_{R,j}$ wird mit dem Wert des multiplikationsfaktors $K_{MD}$ bzw. $K_{MD,j}$ multipliziert. Ausserdem werden ab einem Startaugenblick jeweils für jede Einphasen-Messeinheit 7 getrennt während eines Zeitfensters $n_S/f_S$ bzw. $n_S/f_{S,j}$ Impulse gezählt, deren Frequenz $K_{MD}.f_R$ bzw. $K_{MD,j}.f_{R,j}$ gleich der mit dem Frequenzmultiplikationsfaktor $K_{MD}$ bzw. $K_{MD,j}$ multiplizierten Referenzfrequenz $f_R$ bzw. $f_{R,j}$ ist. Ein so erhaltener Zählwert $n_G$ bzw. $n_{G,j}$ einer jeden Einphasen-Messeinheit 7 wird als ein der letzteren zugehöriger Wert eines Kalibrationsfaktors $K_g$ bzw. $K_{g,j}$ im Speicher 24 des zugehörigen Elektrizitätszählers 1 bzw. 60 gespeichert, wo er im Betrieb bei jeder Messung der Energie abgerufen wird, wenn nur in einem einzigen Leistungsbereich kalibriert wird, bzw. bei derjenigen Messung der Energie abgerufen wird, deren zugehörige Leistung $p_j$ im entsprechenden Leistungsbereich a, b, c oder d liegt, um anschliessend, nach seiner Multiplikation mit einem Korrekturfaktor $K_x$ der betreffenden Einphasen-Messeinheit 7 als im Augenblick geltender Wert des Kalibrations- und Korrekturfaktors $K_{gg} = K_x.K_g$ bzw. $K_{gg,j} = K_x.K_{g,j}$ zugeführt zu werden.

Dabei werden z. B. bei der Unterteilung des Leistungsmessbereichs in mehreren Leistungsbereichen a, b, c und d anlässlich der Kalibration für jeden Leistungsbereich a, b, c und d getrennt die zugehörigen Werte des Kalibrationsfaktors $K_{g,j}$ ermittelt und im Speicher 24 abgespeichert. Im Betrieb wird dann bei jeder Messung der Energie die der letzteren zugehörigen Leistung $p_j$ gemessen und mit den Leistungs-Grenzwerten 0, P1, P2 und P3 der Leistungsbereiche a, b, c und d verglichen zwecks Ermittlung desjenigen Leistungsbereichs, in welchem die zur gemessenen Energie gehörende Leistung $p_j$ liegt. Anschliessend wird dann für jede Einphasen-Messeinheit 7 aus dem Speicher 24 der zu kalibrierenden Elektrizitätszähler 1 bzw. 60 der zum betreffenden Leistungsbereich a, b, c oder d gehörende Wert des Kalibrationsfaktors $K_{g,j}$ abgerufen zwecks nachfolgender Multiplikation mit dem Korrekturfaktor $K_x$. In diesem Fall ist in den zu kalibrierenden Elektrizitätszählern 1 bzw. 60 jeweils eine Leistungs-Messanordnung 75 enthalten zur Ermittlung des Leistungsbereichs a, b, c oder d, in dem die zur gemessenen Energie gehörende Leistung $p_j$ liegt. Die Leistungs-Messanordnung 75 enthält einen Leistungs-Mess-Sensor 76, dessen Ausgang auf einen Eingang einer Abtast- und Halteschaltung 77 geführt ist, sowie je einen Komparator 78, 79, 80 und 81 pro wählbaren Leistungsbereich a, b, c und d. Der Ausgang der Abtast- und Halteschaltung 77 ist auf einen ersten Eingang der Komparatoren 78, 79, 80 und 81 geführt, an deren zweite Eingänge je einer der Leistungs-Grenzwerte 0, P1, P2 oder P3 der Leistungsbereiche a, b, c und d ansteht, während die Ausgänge der Komparatoren 78, 79, 80 und 81 über eine Busverbindung 82 mit dem in den Elektrizitätszählern 1 bzw. 60 enthaltenen Mikrocomputer 74 verbunden sind. Die Komparatoren 78, 79, 80 und 81 ermitteln durch einen Vergleich des mittels des Leistungs-Mess-Sensors 76 und der Abtast- und Halteschaltung 77 ermittelten Wertes der Leistung $p_j$ mit den Leistungs-Grenzwerten 0, P1, P2 und P3 den Leistungsbereich a, b, c oder d, in welchem der Elektrizitätszähler 1 bzw. 60 gerade augenblicklich betrieben wird.

Die Komparatoren 78 bis 81 können jedoch auch durch einen einzigen Analog/Digital-Wandler 83 ersetzt werden, wobei dann, wie in der Fig. 20 dargestellt, der Ausgang der Abtast- und Halteschaltung 77 mit einem Analogeingang des Analog/Digital-Wandlers 83 verbunden ist, während dessen Digitalausgänge über die Busverbindung 82 mit dem Mikrocomputer 74 verbunden sind. Die Leistungs-Grenzwerte 0, P1, P2 und P3 der wählbaren Leistungsbereiche a, b, c und d sind in diesem Fall in digitaler Form im Speicher 24 des Mikrocomputers 74 gespeichert. Der Mikrocomputer 74 ermittelt dann selber durch einen Vergleich des mittels des Analog/Digtal-Wandlers in digitaler Form ermittelten Wertes der Leistung $p_j$ mit den abgespeicherten digitalen Leistungs-Grenzwerten 0, P1, P2 und P3 den Leistungsbereich a, b, c oder d, in welchem der Elektrizitätszähler 1 bzw. 60 gerade augenblicklich betrieben wird. Der Mikrocomputer 74 ruft dann aus seinem Speicher 24 einen diesem ermittelten Leistungsbereich zugehörigen Wert des Kalibrationsfaktors $K_{g,j}$ ab, um diesen dann, nach dessen Multiplikation mit dem Korrekturfaktor $K_x$, an die Frequenzmultiplizierer 22 weiterzuleiten. Der Mikrocomputer 74 kann somit zwischen den einzelnen Leistungsbereichen a, b, c und d des Gesamt-Leistungsmessbereichs unterscheiden und dementsprechend zwischen unterschiedlichen diskreten Werten $K_{g,j}$ des Kalibrationsfaktors umschalten, wodurch eine verbesserte und bereichsweise erzielte Kalibration der Elektrizitätszähler 1 bzw. 60 erfolgt, was eine korrigierte Fehlerkennlinie III ergibt, die einer horizontalen Kennlinie angenäherter ist als die Kennlinie II.

Es ist aber auch möglich, dass nur in einem der Leistungsbereiche, z. B. im Leistungsbereich c, bei einem vorgegebenen mittleren Leistungswert $p_j = p_3$ des Leistungsbereichs c kalibriert wird und in den anderen Leistungsbereichen a, b und d anschliessend entsprechend einer vorgegebenen und aus diskreten Werten bestehenden und in Funktion der Leistung ermittelten Korrekturkennlinie korrigiert wird, deren diskrete Werte im Speicher 24 gespeichert sind. In diesem Fall werden bei der Unterteilung des Leistungsmessbereichs in mehreren Leistungsbereichen a, b, c und d anlässlich der Kalibration nur für einen einzigen Leistungsbereich, z. B. für den Leistungsbereich c, mit j = 3, die zu jeder Einphasen-Messeinheit 7 gehörenden Werte des Kalibrationsfaktors $K_{g,3}$ ermittelt und im Speicher 24 abgespeichert. Im Betrieb wird dann bei jeder Messung der Energie die der letzteren zugehörige Leistung $p_j$ gemessen. Die anlässlich der Kalibration für jede Einphasen-Messeinheit 7 ermittelten und im Speicher 24 abgespeicherten Werte des Kalibrationsfaktors $K_{g,3}$ werden dann abgerufen und mit einem ebenfalls abgerufenen zur gemessenen Leistung $p_j$ gehörenden diskreten Wert der Korrekturkennlinie multipliziert zwecks Bildung von für die betreffende Leistung $p_j$ geltenden korrigierten fiktiven Werten der Kalibrationsfaktoren $K_{g,j}$, mit j = 1, 2 und 4, der Einphasen-Messeinheiten 7. Dabei werden anschliessend dann die ermittelten korrigierten fiktiven Werte der Kalibrationsfaktoren $K_{g,j}$ der Einphasen-Messeinheiten 7 noch mit dem Korrekturfaktor $K_x$ multipliziert werden zwecks Erhalt der Werte der Kalibrations- und Korrekturfaktoren $K_{gg,j} = K_x \cdot K_{g,j}$.

Der Leistungs-Mess-Sensor 76 ist vorzugsweise der Leistungs-Mess-Sensor 10, dem ein nicht dargestelltes Zeitmessglied zur Messung der Impulsperiode $T_{E,j}$ nachgeschaltet ist, wobei dann die gesuchte Leistung $p_j$ die mittlere Leistung $E_P/T_{E,j} = 1/T_{E,j}$ ist.

## Patentansprüche

1. Verfahren zur Kalibration von Einphasen-Messeinheiten (7) eines zu kalibrierenden Elektrizitätszählers (1, 60) mit einem Referenz-Elektrizitätszähler (2), wobei die Einphasen-Messeinheiten (7) und der Referenz-Elektrizitätszähler (2) je eine gleiche Leistung ($p = u.i$, $p_j = u_j.i_j$) messen und je eine Impulsfrequenz ($f_E$ bzw. $f_R$ oder $f_{E,j}$ bzw. $f_{R,j}$) aufweisen, die proportional einer jeweils von ihnen gemessenen Leistung ist, wobei die Impulsfrequenz ($f_R$, $f_{R,j}$) des Referenz-Elektrizitätszählers (2) eine an einem Impulsausgang (6) desselben anstehende Referenzfrequenz ist und mit einem Wert eines Frequenzmultiplikationsfaktors $K_{MD}$ beziehungsweise $K_{MD,j}$ multipliziert wird zwecks Erzeugung von Impulsen, die ab einem Startaugenblick während eines Zeiffensters gezählt werden, wobei ein so erhaltener Zählwert ($n_G$ bzw. $n_{G,j}$) einer jeden Einphasen-Messeinheit (7) in einem Speicher (24) gespeichert wird, dadurch gekennzeichnet, dass die Kalibration selbsttätig und der Speicher (24) ein Speicher des zu kalibrierenden Elektrizitätszählers (1, 60) ist, dass der Zählwert ($n_G$ bzw. $n_{Gj}$) ein der betreffenden Einphasen-Messeinheit (7) zugehöriger Wert eines Kalibrationsfaktors ($K_g$ bzw. $K_{g,j}$) ist, der im Betrieb bei der Messung einer Energie abgerufen wird und nach seiner Multiplikation mit einem Korrekturfaktor ($K_X$) der betreffenden Einphasen-Messeinheit (7) als Wert eines Kalibrations- und Korrekturfaktors ($k_{gg} = K_x.k_g$ bzw. $k_{gg,j} = K_x.K_{g,j}$) gilt, dass in jeder Einphasen-Messeinheit (7) deren Impulsfrequenz ($f_E$ bzw. $f_{E,j}$) mit dem Wert des Kalibrations-und Korrekturfaktors ($K_{gg}$ bzw. $K_{gg,j}$) multipliziert wird zwecks Erzeugung einer Frequenz $f_s$ beziehungsweise $f_{s,j}$, dass ein vorgegebener Wert einer Zahl $n_s$ abrufbar im Speicher (24) gespeichert ist, dass für die Einphasen-Messeinheiten (7) das Zeiffenster jeweils gleich $n_S/f_S$ beziehungsweise $n_S/f_{S,j}$ ist und dass der Wert des Frequenzmultiplikationsfaktors $K_{MD}$ oder $K_{MD,j}$ gleich $[R_Z/R_R].[K_A/n_S]$ beziehungsweise gleich $[R_Z/R_{R,j}].[K_A/n_S]$ ist und abrufbar im Speicher (24) gespeichert ist, wobei $R_R$ beziehungsweise $R_{R,j}$ die Anzahl Impulse pro Energieeinheit der am Impulsausgang (6) des Referenz-Elektrizitätszählers (2) anstehenden Impulse ist, $R_z$ eine Zählerkonstante ist und die Anzahl der Impulse pro gemessene Energieeinheit, z. B. pro kWh, darstellt, die am Ausgang des kalibrierten und mit einer Zähleranpassung $K_A$ versehenenen Elektrizitätszählers (1, 60) anstehen, und die Zähleranpassung $K_A$ ein durch einen Ausgangsimpuls des kalibrierten Elektrizitätszählers (1, 60) dargestelltes Energiequantum ist, wenn ein durch einen Impuls der Frequenz $f_S$ beziehungsweise $f_S$,j dargestelltes Energiequantum eine Energieeinheit, z. B. eine kWh, ist.

2. Verfahren nach Anspruch 1, dadurch gekennzeichnet, dass der Referenz-Elektrizitätszähler (2) eine vorgegebene Energieart, z. B. Wirkenergie, und der zu kalibrierende Elektrizitätszähler (1, 60) eine oder mehrere Energiearte, z. B. Wirkund Blindenergie, misst und dass zum Messen je einer gleichen Leistung ($p = u.i$, $p_j = u_j.i_j$) Eingänge der Einphasen-Messeinheiten (7) und des Referenz-Elektrizitätszählers (2) unmittelbar oder über Phasenschieber (5) gespeist werden.

3. Verfahren nach Anspruch 1 oder 2, dadurch gekennzeichnet, dass der zu kalibrierende Elektrizitätszähler (1, 60) einen Referenzsignal-Eingang (16) aufweist, der mit den am Impulsausgang (6) des Referenz-Elektrizitätszählers (2) anstehenden Impulsen gespeist wird.

4. Verfahren nach einem der Ansprüche 1 bis 3, dadurch gekennzeichnet, dass der Leistungsmessbereich des zu kalibrierenden Elektrizitätszählers (1, 60) in einem oder mehreren Leistungsbereichen (c bzw. a, b, c, d) unterteilt wird und für mindestens einem der letzteren Leistungsbereiche (c bzw. a, b, c, d) das Verfahren durchgeführt wird.

5. Verfahren nach Anspruch 4, dadurch gekennzeichnet, dass bei der Unterteilung des Leistungsmessbereichs in mehreren Leistungsbereichen (a, b, c, d) anlässlich der Kalibration für jeden Leistungsbereich (a, b, c und d) getrennt die zugehörigen Werte des Kalibrationsfaktors ($K_{g,j}$) ermittelt und im Speicher (24) abgespeichert werden, dass im Betrieb bei jeder Messung der Energie, die der letzteren zugehörigen Leistung ($p_j$) gemessen und mit Leistungs-Grenzwerten (0, P1, P2, P3) der Leistungsbereiche (a, b, c, d) verglichen wird zwecks Ermittlung desjenigen Leistungsbereichs, in welchem die zur gemessenen Energie gehörende Leistung ($p_j$) liegt, und dass für jede Einphasen-Messeinheit (7) aus dem Speicher (24) der zu kalibrierenden Elektrizitätszähler (1, 60) der zum betreffenden Leistungsbereich (a, b, c oder d) gehörende Wert des Kalibrationsfaktors ($K_{g,j}$) abgerufen wird zwecks anschliessender Multiplikation mit dem Korrekturfaktor ($K_x$).

6. Verfahren nach Anspruch 5, dadurch gekennzeichnet,

   - dass bei der Unterteilung des Leistungsmessbereichs in mehreren Leistungsbereichen (a, b, c, d) anlässlich der Kalibration nur für einen einzigen Leistungsbereich (z. B.: c mit j = 3) die zu jeder Einphasen-Messeinheit (7) gehörenden Werte des Kalibrationsfaktors ($K_{g,3}$) ermittelt und im Speicher (24) abgespeichert werden,
   - dass im Speicher (24) diskrete Werte einer in Funktion der Leistungen ermittelten Korrekturkennlinie gespeichert werden,
   - dass im Betrieb bei jeder Messung der Energie die der Energie zugehörigen Leistung ($p_j$) gemessen wird,
   - dass die anlässlich der Kalibration für jede Einphasen-Messeinheit (7) ermittelten und im Speicher (24) abgespeicherten Werte des Kalibrationsfaktors ($K_{g,3}$) abgerufen werden und mit einem ebenfalls abgerufen, zur gemessenen Leistung ($p_j$) gehörenden diskreten Wert der Korrekturkennlinie multipliziert werden zwecks Bildung von für die betreffende Leistung ($p_j$) geltenden korrigierten Werten der Kalibrationsfaktoren ($K_{g,j}$, mit j = 1, 2, 4) der Einphasen-Messeinheiten (7) und
   - dass dann die ermittelten korrigierten Werte der Kalibrationsfaktoren ($K_{g,j}$) der Einphasen-Messeinheiten (7) mit dem Korrekturfaktor ($K_x$) multipliziert werden.

7. Verfahren nach einem der Ansprüche 1 bis 6, dadurch gekennzeichnet, dass im Kalibrations-Augenblick für den Korrekturfaktor ($K_x$) ein Wert Eins gewählt wird.

8. Verfahren nach einem der Ansprüche 1 bis 7, dadurch gekennzeichnet, dass im Betrieb der Korrekturfaktor ($K_x$)

**EP 0 569 740 B1**

ein Produkt von Parametereinfluss-Korrekturfaktoren ($K_T$, $K_f$, $K_W$) ist, wobei einer oder mehrere der Parametereinfluss-Korrekturfaktoren ($K_T$, $K_f$, $K_W$) einen Wert Eins besitzen kann.

9. Verfahren nach Anspruch 8, dadurch gekennzeichnet, dass einer der Parametereinfluss-Korrekturfaktoren ($K_T$, $K_f$, $K_W$) ein Temperatureinfluss-Korrekturfaktor ($K_T$) und eine inverse Funktion eines Temperaturabhängigkeits-Faktors ($1/K_T$) ist, mit dem eine Temperatur die Messresultate der zu kalibrierenden Elektrizitätszähler (1, 60) beeinflusst.

10. Verfahren nach Anspruch 8 oder 9, dadurch gekennzeichnet, dass einer der Parametereinfluss-Korrekturfaktoren ($K_T$, $K_f$, $K_W$) ein Frequenzeinfluss-Faktor ($K_f$) und eine inverse Funktion eines Frequenzabhängigkeits-Faktors ($1/K_f$) ist, mit dem eine Frequenz die Messresultate der zu kalibrierenden Elektrizitätszähler (1, 60) beeinflusst.

11. Verfahren nach einem der Ansprüche 8 bis 10, dadurch gekennzeichnet, dass einer der Parametereinfluss-Korrekturfaktoren ($K_T$, $K_f$, $K_W$) ein Wandlerfehlereinfluss-Faktor ($K_W$) und eine inverse Funktion eines Wandlerfehlerabhängigkeits-Faktors ($1/K_W$) ist, mit dem ein Fehler von Wandlern, die den zu kalibrierenden Elektrizitätszählern (1, 60) vorgeschaltet sind, die Messresultate der letzteren beeinflusst.

12. Zu kalibrierender Elektrizitätszähler (1, 60) zur Durchführung des Verfahrens nach einem der Ansprüche 1 bis 12, wobei der zu kalibrierende Elektrizitätszähler (1, 60) mindestens eine Einphasen-Messeinheit (7) enthält, in der ein Frequenzausgang (27) eines Leistungs-Mess-Sensors (10) auf einen Eingang eines ersten Frequenzmultiplizierers (22) geführt ist, dessen Ausgang mit einem Takteingang eines ersten Zählers (37) verbunden ist, wobei ein Übertrag-Ausgang des ersten Zählers (37) auf einen Eingang eines Freigabegatters (38) geführt ist und ein Referenzsignal-Eingang (17) der Einphasen-Messeinheit (7) über einen zweiten Frequenzmultiplizierer (40) mit einem weiteren Eingang des Freigabegatters (38) verbunden ist, dessen Ausgang auf einen Takteingang eines zweiten Zählers (39) geführt ist, und wobei ein Parallelausgang des zweiten Zählers (39) mit einem Schreibeingang eines Speichers (24) und ein Ausgang des Speichers (24) mit einem weiteren Eingang des ersten Frequenzmultiplizierers (22) verbunden ist.

13. Zu kalibrierender Elektrizitätszähler (1, 60) nach Anspruch 12, dadurch gekennzeichnet, dass der Ausgang des ersten Frequenzmultiplizierers (22) auf einen ersten Eingang eines weiteren Freigabegatters (36) geführt ist, wobei ein zweiter Eingang des weiteren Freigabegatters (36) von einem externen Steuersignal (ST) gespeist ist und ein Ausgang des weiteren Freigabegatters (36) mit einem Rückstell-Eingang (R) des ersten Zählers (37) verbunden ist.

14. Zu kalibrierender Elektrizitätszähler (1, 60) nach Anspruch 12, dadurch gekennzeichnet, dass ein Mikrocomputer (74) im zu kalibrierenden Elektrizitätszähler (1, 60) enthalten ist zur Ermittlung der Werte von Kalibrationsfaktoren ($K_g$).

15. Zu kalibrierender Elektrizitätszähler (1, 60) nach einem der Ansprüche 12 bis 14, dadurch gekennzeichnet, dass der Speicher (24) des zu kalibrierenden Elektrizitätszählers (1, 60) ein unverlierbarer Speicher ist.

16. Zu kalibrierender Elektrizitätszähler (1, 60) nach einem der Ansprüche 12 bis 15, dadurch gekennzeichnet, dass der Speicher (24) einen Hardware-Schreibschutz besitzt, dessen Sperrung im Startaugenblick durch ein externes Steuersignal (ST) aufhebbar ist.

17. Zu kalibrierender Elelktrizitätszähler (1, 60) nach einem der Ansprüche 12 bis 16, dadurch gekennzeichnet, dass im zu kalibrierenden Elektrizitätszähler (1, 60) je eine Parameter-Messanordnung (67) pro vorhandenen Parametereinfluss-Korrekturfaktor ($K_T$, $K_f$, $K_W$) enthalten ist zur Ermittlung der Werte des betreffenden Parametereinfluss-Korrekturfaktors ($K_T$, $K_f$, $K_W$).

18. Zu kalibrierender Elektrizitätszähler (1, 60) nach Anspruch 17, dadurch gekennzeichnet, dass die Parameter-Messanordnung (67), in der angegebenen Reihenfolge in einer Kettenschaltung hintereinander geschaltet, einen Parameter-Mess-Sensor (68) zur fortlaufenden Messung des Augenblickswertes eines zugehörigen Parameters ($x[t]$), eine Abtast- und Halte-Schaltung (69) zur periodischen Abtastung und Speicherung der gemessenen Werte des zugehörigen Parameters ($x[t]$), einen Analog/Digital-Wandler (70) zur Umwandlung der so erhaltenen analogen Abtastwerte in Digitalwerte und einen Codierer (71) zur Umcodierung der Digitalwerte in einen zugehörigen Wert des Korrekturfaktors ($K_T$, $K_f$, $K_W$) enthält, der über eine Busverbindung (73) einem in den Elektrizitätszählern (1, 60) enthaltenen Mikrocomputer (74) zugeführt ist zur Berechnung der Werte des Kalibrations- und Korrekturfaktors ($K_{gg}$, $K_{gg,j}$).

**19.** Zu kalibrierender Elektrizitätszähler (1, 60) nach einem der Ansprüche 12 bis 18, dadurch gekennzeichnet, dass in den zu kalibrierenden Elektrizitätszählern (1, 60) je eine Leistungs-Messanordnung (75) enthalten ist zur Ermittlung des Leistungsbereichs (a, b, c, d), in dem die zur gemessenen Energie gehörende Leistung liegt.

**20.** Zu kalibrierender Elektrizitätszähler (1, 60) nach Anspruch 19, dadurch gekennzeichnet, dass die Leistungs-Messanordnung (75) einen Leistungs-Mess-Sensor (76) enthält, dessen Ausgang auf einen Eingang einer Abtast- und Halteschaltung (77) geführt ist, dass in der Leistungs-Messanordnung (75) je ein Komparator (78, 79, 80, 81) pro wählbaren Leistungsbereich (a, b, c, d) enthalten ist und der Ausgang der Abtast- und Halteschaltung (77) auf einen ersten Eingang der Komparatoren (78, 79, 80, 81) geführt ist, an deren zweite Eingänge je ein Leistungs-Grenzwert (0, P1, P2, P3) der Leistungsbereiche (a, b, c, d) ansteht, während die Ausgänge der Komparatoren (78, 79, 80, 81) über eine Busverbindung (82) mit einem in den Elektrizitätszählern (1, 60) enthaltenen Mikrocomputer (74) verbunden sind.

**21.** Zu kalibrierender Elektrizitätszähler (1, 60) nach Anspruch 19, dadurch gekennzeichnet, dass die Leistungs-Messanordnung (75) einen Leistungs-Mess-Sensor (76) enthält, dessen Ausgang auf einen Eingang einer Abtast- und Halteschaltung (77) geführt ist, deren Ausgang mit einem Analogeingang eines Analog/Digital-Wandlers (83) verbunden ist, dessen Digitalausgänge über eine Busverbindung (82) mit einem in den Elektrizitätszählern (1, 60) enthaltenen Mikrocomputer (74) verbunden sind, und dass Leistungs-Grenzwerte (0, P1, P2, P3) von wählbaren Leistungsbereichen (a, b, c, d) in digitaler Form im Speicher (24) des Mikrocomputers (74) gespeichert sind.

## Claims

**1.** A method of calibrating single-phase measuring units (7) of an electricity meter (1, 60) to be calibrated with a reference electricity meter (2), wherein the single-phase measuring units (7) and the reference electricity meter (2) each measure the same power ($p=u.i, p_j=u_j.i_j$) and each have a pulse frequency ($f_E$ and $f_R$ or $f_{Ej}$ and $f_{Rj}$) respectively) which is proportional to a respective power measured by them, wherein the pulse frequency ($f_R$, $f_{Rj}$) of the reference electricity meter (2) is a reference frequency which occurs at a pulse output (6) thereof and is multiplied by a value of a frequency multiplication factor $K_{MD}$ and $K_{MDj}$ respectively for the purposes of generating pulses which are counted from a start time during a time window, wherein a count value ($n_G$ and $n_{Gj}$ respectively) obtained in that way of each single-phase measuring units (7) is stored in a memory (24), characterised in that calibration is automatic and the memory (24) is a memory of the electricity meter (1,60) to be calibrated, that the count value ($n_G$ and $n_{Gj}$ respectively) is a value, associated with the respective single-phase measuring units (7), of a calibration factor ($K_g$ and $K_{gj}$) which is called up in operation when measuring an energy and after multiplication thereof by a correction factor ($K_x$) of the single-phase measuring unit (7) in question applies as a value of a calibration and correction factor ($K_{gg}=K_x.K_g$ and $K_{ggj}=K_x.K_{gj}$ respectively), that in each single-phase measuring unit (7) the pulse frequency ($f_E$ and $f_{Ej}$ respectively) is multiplied by the value of the calibration and correction factor ($K_{gg}$ and $K_{ggj}$ respectively) for the purposes of producing a frequency $f_S$ and $f_{Sj}$ respectively, that a predetermined value of a number $n_S$ is stored in the memory (24) in such a way that it can be called up, that for the single-phase measuring units (7) the time window is respectively equal to $n_S/f_S$ and $n_S/f_{Sj}$ respectively and that the value of the frequency multiplication factor $K_{MD}$ or $K_{MDj}$ is equal to $[R_Z/R_R].[K_A/n_S]$ and equal to $[R_Z/R_{Rj}].[K_A/n_S]$ respectively and is stored in the memory (24) in such a way that it can be called up, wherein $R_R$ and $R_{Rj}$ respectively is the number of pulses per energy unit of the pulses at the pulse output (6) of the reference electricity meter (2), $R_Z$ is a counter constant and represents the number of pulses per measured energy unit, for example per kwh, which occur at the output of the calibrated electricity meter (1,60) provided with a counter adaptation $K_A$ and the counter adaptation $K_A$ is an energy quantum represented by an output pulse of the calibrated electricity meter (1,60) when an energy quantum represented by a pulse of the frequency $f_S$ and $f_{Sj}$ respectively is an energy unit, for example one kWh.

**2.** A method according to claim 1 characterised in that the reference electricity meter (2) measures a predetermined kind of energy, for example active energy, and the electricity meter (1,60) to be calibrated measures one or more kinds of energy, for example active and reactive energy, and that for measuring the respective same power ($p$ u. $i$, $p_j = u_j.i_j$), inputs of the single-phase measuring units (7) and the reference electricity meter (2) are fed directly or by way of phase shifters (5)

**3.** A method according to claim 1 or claim 2 characterised in that the electricity meter (1,60) to be calibrated has a reference input (16) which is fed with the pulses occurring at the pulse output (6) of the reference electricity meter (2).

4. A method according to one of claims 1 to 3 characterised in that the power measuring range of the electricity meter (1,60) to be calibrated is subdivided into one or more power ranges (c and a, b, c, d respectively) and the method is carried into effect for at least one of the latter power ranges (c and a, b, c, d respectively).

5. A method according to claim 4 characterised in that when the power measuring range is subdivided into a plurality of power ranges (a, b, c, d,) on the occasion of calibration for each power range (a, b, c and d) the associated values of the calibration factor ($K_{g,j}$) are separately ascertained and stored in the memory (24), that in operation in each measurement of energy the power ($p_j$) associated with the latter is measured and compared to power limit values (0, P1, P2, P3) of the power ranges (a, b, c, d) for the purposes of ascertaining that power range in which the power ($p_j$) associated with the measured energy lies, and that for each single-phase measuring unit (7) the value of the calibration factor ($K_{g,j}$) associated with the power range (a, b, c or d) in question is called up from the memory (24) of the electricity meter (1,60) to be calibrated for the purposes of subsequent multiplication by the correction factor ($K_x$).

6. A method according to claim 5 characterised in that

- when the power measuring range is subdivided into a plurality of power ranges (a, b, c, d) on the occasion of the calibration operation only for a single power range (for example: c with j = 3) the values of the calibration factor ($K_{g,3}$) which are associated with each single-phase measuring unit (7) are ascertained and stored in the memory (24),
- discrete values of a correction curve ascertained in dependence on the powers are stored in the memory (24),
- in operation in each measurement of the energy the power ($p_j$) associated with the energy is measured,
- the values of the calibration factor ($K_{g,3}$) which are ascertained on the occasion of the calibration operation for each single-phase measuring unit (7) and stored in the memory (24) are called up and multiplied by a discrete value of the correction curve, which is also called up and which is associated with the measured power ($p_j$), for the purposes of forming corrected values, applicable in respect of the power ($p_j$) in question, of the calibration factors ($K_{g,j}$ with j = 1, 2, 4) of the single-phase measuring units (7), and
- then the ascertained corrected values of the calibration factors ($K_{g,j}$) of the single-phase measuring units (7) are multiplied by the correction factor ($K_x$).

7. A method according to one of claims 1 to 6 characterised in that a value one is adopted at the calibration time for the correction factor ($K_x$).

8. A method according to one of claims 1 to 7 characterised in that in operation the correction factor ($K_x$) is a product of parameter influence correction factors ($K_T$, $K_f$, $K_W$), wherein one or more of the parameter influence correction factors ($K_T$, $K_f$, $K_W$) can be of a value one.

9. A method according to claim 8 characterised in that one of the parameter influence correction factors ($K_T$, $K_f$, $K_W$) is a temperature influence correction factor ($K_T$) and is an inverse function of a temperature dependency factor ($1/K_T$) with which a temperature influences the measurement results of the electricity meters (1,60) to be calibrated.

10. A method according to claim 8 or claim 9 characterised in that one of the parameter influence correction factors ($K_T$, $K_f$, $K_W$) is a frequency influence factor ($K_f$) and is an inverse function of a frequency dependency factor ($1/K_f$) with which a frequency influences the measurement results of the electricity meters (1,60) to be calibrated.

11. A method according to one of claims 8 to 10 characterised in that one of the parameter influence correction factors ($K_T$, $K_f$, $K_W$) is a converter error influence factor ($K_W$) and is an inverse function of a converter error dependency factor ($1/K_W$) with which an error of converters which are connected upstream of the electricity meters (1,60) to be calibrated influences the measurement results of the latter.

12. An electricity meter (1,60) to be calibrated, for carrying out the method according to one of claims 1 to 12 wherein the electricity meter (1,60) to be calibrated includes at least one single-phase measuring unit (7) in which a frequency output (27) of a power measuring sensor (10) is taken to an input of a first frequency multiplier (22) whose output is connected to a clock input of a first counter (37), wherein a carry output of the first counter (37) is taken to an input of an enable gate (38) and a reference input (17) of the single-phase measuring unit (7) is connected by way of a second frequency multiplier (40) to a further input of the enable gate (38), whose output is taken to a clock input of a second counter (39), and wherein a parallel output of the second counter (39) is connected to a write input of a memory (24) and an output of the memory (24) is connected to a further input of the first frequency multiplier (22).

**13.** An electricity meter (1,60) to be calibrated according to claim 12 characterised in that the output of the first frequency multiplier (22) is taken to a first input of a further enable gate (36), wherein a second input of the further enable gate (36) is fed by an external control signal (ST) and an output of the further enable gate (36) is connected to a reset input (R) of the first counter (37).

**14.** An electricity meter (1,60) to be calibrated according to claim 12 characterised in that a microcomputer (74) is included in the electricity meter (1,60) to be calibrated to ascertain the values of calibration factors ($K_g$).

**15.** An electricity meter (1,60) to be calibrated according to one of claims 12 to 14 characterised in that the memory (24) of the electricity meter (1,60) to be calibrated is a non-volatile memory.

**16.** An electricity meter (1,60) to be calibrated according to one of claims 12 to 15 characterised in that the memory (24) has a hardware write protection, the blocking action of which can be removed at the start time by an external control signal (ST).

**17.** An electricity meter (1,60) to be calibrated according to one of claims 12 to 16 characterised in that included in the electricity meter (1,60) to be calibrated is a respective parameter measuring arrangement (67) for each parameter influence correction factor ($K_T$, $K_f$, $K_W$) present, for ascertaining the values of the parameter influence correction factor ($K_T$, $K_f$, $K_W$) in question.

**18.** An electricity meter (1,60) to be calibrated according to claim 17 characterised in that the parameter measuring arrangement (67) includes, connected in succession in the specified sequence in a cascade circuit, a parameter measuring sensor (68) for continuously measuring the instantaneous value of an associated parameter (x[t]), a sample and hold circuit (69) for periodically sampling and storing the measured values of the associated parameter (x[t]), an analog/digital converter (70) for conversion of the analog sample values obtained in that way into digital values, and an encoder (71) for recoding the digital values into an associated value of the correction factor ($K_T$, $K_f$, $K_W$) which is fed by way of a bus connection (73) to a microcomputer (74) contained in the electricity meters (1,60), for calculation of the values of the calibration and correction factor ($K_{gg}$, $K_{gg,j}$).

**19.** An electricity meter (1,60) to be calibrated according to one of claims 12 to 18 characterised in that contained in the electricity meters (1,60) to be calibrated in a respective power measuring arrangement (75) for ascertaining the power range (a, b, c, d) in which the power associated with the measured energy lies.

**20.** An electricity meter (1,60) to be calibrated according to claim 19 characterised in that the power measuring arrangement (75) includes a power measuring sensor (76) whose output is taken to an input of a sample and hold circuit (77), that included in the power measuring arrangement (75) is a respective comparator (78, 79, 80, 81) for each selectable power range (a, b, c, d) and the output of the sample and hold circuit (77) is taken to a first input of the comparators (78, 79, 80, 81), at the second inputs of which is a respective power limit value (0, P1, P2, P3) of the power ranges (a, b, c, d), while the outputs of the comparators 78, 79, 80, 81) are connected by way of a bus connection (82) to a microcomputer (74) contained in the electricity meters (1,60).

**21.** An electricity meter (1,60) to be calibrated claim 19 characterised in that the power measuring arrangement (75) includes a power measuring sensor (76) whose output is taken to an input of a sample and hold circuit (77) whose output is connected to an analog input of an analog/digital converter (83) whose digital outputs are connected by way of a bus connection (82) to a microcomputer (74) contained in the electricity meters (1,60) and that power limit values (0, P1, P2, P3) of selectable power ranges (a, b, c, d) are stored in digital form in the memory (24) of the microcomputer (74).

## Revendications

**1.** Procédé pour étalonner des unités de mesure monophasées (7) d'un compteur d'électricité (1,60) à étalonner comportant un compteur d'électricité de référence (2), selon lequel les unités de mesure monophasées (7) et le compteur d'électricité de référence (2) mesurent une même puissance ($p = u.i$, $p_j = u_j.i_j$) et possède des fréquences respectives d'impulsions ($f_E$ ou $f_R$ ou $f_{Ej}$ ou $f_{Rj}$) qui sont proportionnels à des puissances respectives mesurées par ces compteurs, selon lequel la fréquence d'impulsions ($f_R$, $f_{Rj}$) du compteur d'électricité de référence (2) est une fréquence de référence appliquée à une sortie d'impulsions (6) de ce compteur et multipliée par une valeur d'un facteur de multiplication de fréquence $K_{MD}$ ou $K_{MDj}$, en vue de produire des impulsions qui sont comptées à partir d'un instant de départ pendant un intervalle de temps, et selon lequel une valeur de comptage ainsi obtenue ($n_G$ ou $n_{Gj}$) de chaque unité de mesure monophasée (7) est mémorisée dans une mémoire (24), caractérisé en ce que l'étalonnage est automatique et que la mémoire (24) est une mémoire du compteur d'électricité (1,60) à étalonner, que la valeur de comptage ($n_G$ ou $n_{Gj}$) est une valeur d'un facteur d'étalonnage ($K_g$ ou $K_{gj}$), qui est associé à l'unité de mesure monophasée considérée (7) et qui, en fonctionnement, est appelé lors de la mesure d'une énergie et, après sa multiplication par un facteur de correction ($K_x$) de l'unité de mesure monophasée considérée (7) constitue une valeur d'un facteur d'étalonnage et de correction ($Kgg = K_x.K_g$ ou $K_{ggj} = K_x.K_{gj}$), que dans chaque unité de mesure monophasée (7), sa fréquence d'impulsions ($f_E$ ou $f_{Ej}$) est multipliée par la valeur du facteur d'étalonnage et de correction ($K_{gg}$ ou $K_{ggj}$), pour la production d'une fréquence $f_S$ ou $f_{Sj}$, qu'une valeur prédéterminée d'un nombre $n_S$ est mémorisée dans la mémoire (24) de manière à pouvoir être appelée, que pour les unités de mesure monophasés (7) l'intervalle de temps est respectivement égal à $n_S/f_S$ ou $n_S/f_j$ et que la valeur du facteur de multiplication de fréquence $K_{MD}$, $K_{MDj}$ est égale à $[R_Z/R_R].[K_A/n_S]$ ou à $[R_Z/R_{Rj}].[K_A/n_S]$ et est mémorisée dans la mémoire (24), $R_R$ ou $R_{Rj}$ étant le nombre d'impulsions par unité d'énergie des impulsions présentes sur la sortie d'impulsions (6) du compteur d'électricité de référence (2), $R_Z$ est une constante du compteur et représente le nombre des impulsions par unité d'énergie mesurée, par exemple par kilowattheure (kWh), qui apparaissent à la sortie du compteur d'électricité (1,60) étalonné et comportant un coefficient $K_A$ d'adaptation du compteur, et que le coefficient $K_A$ d'adaptation du compteur est un quantum d'énergie représenté par une impulsion de sortie du compteur d'électricité étalonné (1,60), lorsqu'un quantum d'énergie représenté par une impulsion présentant la fréquence $f_S$ ou $f_{Sj}$ est une unité d'énergie, par exemple un kWh.

2. Procédé selon la revendication 1, caractérisé en ce que le compteur d'électricité de référence (2) mesure un type d'énergie prédéterminé, par exemple une énergie active, et que le compteur d'électricité devant être étalonné (1,60) mesure un ou plusieurs types d'énergie, par exemple une énergie active et une énergie réactive, et que la mesure respectivement d'une même puissance ($p = u.i$, $p_j = u_j.i_j$), des entrées des unités de mesure monophasées (7) et du compteur d'électricité de référence (2) sont alimentées directement ou par l'intermédiaire de déphaseurs (5).

3. Procédé selon la revendication 1 ou 2, caractérisé en ce que le compteur d'électricité à étalonner (1,60) comporte une entrée (16) pour un signal de référence, qui est alimentée par les impulsions apparaissant à la sortie d'impulsions (6) du compteur d'électricité de référence (2).

4. Procédé selon l'une des revendications 1 à 3, caractérisé en ce que la gamme de mesure de puissance du compteur d'électricité à étalonner (1,60) est subdivisée en une ou plusieurs gammes de puissances (c ou a, b, c, d) et que le procédé est mis en oeuvre pour au moins l'une des dernières gammes de puissances (c ou a, b, c, d).

5. Procédé selon la revendication 4, caractérisé en ce que dans le cas de la subdivision de la gamme de mesure de puissance en plusieurs gammes de puissances (a, b, c, d) à l'occasion de l'étalonnage pour chaque gamme de puissances (a, b, c et d) les valeurs associées du facteur d'étalonnage ($K_{g,j}$) sont déterminées séparément et sont mémorisées dans la mémoire (24), qu'en fonctionnement, lors de chaque mesure de l'énergie, l'énergie de la dernière puissance associée ($p_j$) est mesurée et est comparée à des valeurs limites de puissance (0, P1, P2, P3) des gammes de puissances (a, b, c, d) pour la détermination de la gamme de puissances, dans laquelle est située la puissance ($p_j$) associée à l'énergie mesurée, et que pour chaque unité de mesure monophasée (7), la valeur du facteur d'étalonnage ($K_{g,j}$), qui est associée à la gamme de puissances déterminée (a, b, c et d), est appelée à partir de la mémoire (24) du compteur d'électricité à étalonner (1, 60), pour être multipliée ultérieurement par le facteur de correction ($K_x$).

6. Procédé selon la revendication 5, caractérisé en ce

- que, lors de la subdivision de la gamme de mesure de puissances en plusieurs gammes de puissances (a, b, c, d) à l'occasion de l'étalonnage, les valeurs du facteur d'étalonnage ($k_{g,3}$) associées à chaque unité de mesure monophasée (7) sont déterminées pour une seule gamme de puissances (par exemple c avec j = 3) et sont mémorisées dans la mémoire (24),
- que des valeurs discrètes d'une courbe caractéristique de correction déterminée en fonction des puissances sont mémorisées dans la mémoire (24),
- qu'en fonctionnement, lors de chaque mesure, de l'énergie, la puissance ($p_j$) associée à l'énergie est mesurée,
- que les valeurs du facteur d'étalonnage ($k_{g,3}$), qui sont déterminées à l'occasion de l'étalonnage pour chaque unité de mesure monophasée (7) et sont mémorisées dans la mémoire (24), sont appelées et sont multipliées par une valeur discrète également appelée, qui est associée à la puissance mesurée ($P_j$), de la courbe caractéristique de correction pour former des valeurs corrigées, valable pour la puissance considérée ($p_j$), des facteurs d'étalonnage ($K_{g,j}$, avec j = 1, 2, 4) des unités de mesure monophasées (7), et

- que les valeurs corrigées déterminées des facteurs d'étalonnage ($K_{g,j}$) des unités de mesure monophasées (7) sont alors multipliées par le facteur de correction ($K_x$).

**7.** Procédé selon l'une des revendications 1 à 6, caractérisé en ce qu'une valeur un est choisie à l'instant d'étalonnage pour le facteur de correction ($K_x$).

**8.** Procédé selon l'une des revendications 1 à 7, caractérisé en ce qu'en fonctionnement, le facteur de correction ($K_x$) est un produit de facteurs ($K_T$, $K_f$, $K_W$) de correction de l'influence de paramètres, un ou plusieurs des facteurs ($K_T$, $K_f$, $K_W$) de correction de l'influence de paramètres pouvant posséder une valeur un.

**9.** Procédé selon la revendication 8, caractérisé en ce que l'un des facteurs ($K_T$, $K_f$, $K_W$) de correction de l'influence de paramètres est un facteur ($K_T$) de correction de l'influence de la température et est une fonction inverse d'un facteur ($1/K_T$) de dépendance vis-à-vis de la température, avec lequel une température influe sur les résultats de mesure des compteurs d'électricité à étalonner (1,60).

**10.** Procédé selon la revendication 8 ou 9, caractérisé en ce que l'un des facteurs ($K_T$, $K_f$, $K_W$) de correction de l'influence de paramètres est un facteur ($K_f$) d'influence de la fréquence et est une fonction inverse d'un facteur ($1/K_f$) de dépendance vis-à-vis de la fréquence, avec lequel une fréquence influe sur les résultats de mesure des compteurs d'électricité à étalonner (1,60).

**11.** Procédé selon l'une des revendications 8 à 10, caractérisé en ce que l'un des facteurs ($K_T$, $K_f$, $K_W$) de correction de l'influence de paramètres est un facteur ($K_W$) de l'influence de défauts de transformateurs et est une fonction inverse d'un facteur ($1/K_W$) de dépendance vis-à-vis de l'erreur de convertisseur, avec lequel un défaut de transformateurs, qui sont branchés en amont des compteurs d'électricité à étalonner (1,60), influe sur les résultats de mesure de ces compteurs.

**12.** Compteur d'électricité à étalonner (1,60) pour la mise en oeuvre du procédé selon l'une des revendications 1 à 12, le compteur d'électricité à étalonner (1,60) contenant au moins une unité de mesure monophasée (7), dans laquelle une sortie de fréquence (27) d'un capteur de mesure de puissance (10) est envoyée à une entrée d'un premier multiplicateur de fréquence (22), dont la sortie est reliée à une entrée de cadence d'un premier compteur (37), dans lequel une sortie de report du premier compteur (37) est envoyée à une entrée d'une porte de libération (38) et une entrée (17) du signal de référence de l'unité de mesure monophasée (7) est reliée par l'intermédiaire d'un second multiplicateur de fréquence (40) à une autre entrée de la porte de libération (38), dont la sortie est reliée à une entrée de cadence d'un second compteur (39), et dans lequel une sortie parallèle du second compteur (39) est reliée à une entrée d'enregistrement d'une mémoire (24), et une sortie de la mémoire (24) est reliée à une autre entrée du premier multiplicateur de fréquence (22).

**13.** Compteur d'électricité à étalonner (1,60) selon la revendication 12, caractérisé en ce que la sortie du premier multiplicateur de fréquence (22) est raccordée à une première entrée d'une autre porte de libération (36), une seconde entrée de l'autre porte de libération (36) étant alimentée par un signal de commande externe (ST), tandis qu'une sortie de l'autre porte de libération (36) est reliée à une entrée de remise à zéro (R) du premier compteur (37).

**14.** Compteur d'électricité à étalonner (1,60) selon la revendication 12, caractérisé en ce qu'un micro-ordinateur (74) est présent dans le compteur d'électricité à étalonner (1,60) pour déterminer les valeurs de facteurs d'étalonnage ($K_j$).

**15.** Compteur d'électricité à étzalonner (1,60) selon l'une des revendications 12 à 14, caractérisé en ce que la mémoire (24) du compteur d'électricité à étalonner (1,60) est une mémoire imperdable.

**16.** Compteur d'électricité à étalonner (1,60) selon l'une des revendications 12 à 15, caractérisé en ce que la mémoire (24) possède un dispositif matériel de protection contre l'écriture, dont le blocage peut être supprimé à l'instant de démarrage, par un signal de commande externe (ST).

**17.** Compteur d'électricité à étalonner (1,60) selon l'une des revendications 12 à 16, caractérisé en ce que dans le compteur d'électricité à étalonner (1,60) il est prévu un dispositif respectif de mesure de paramètre (67) pour chaque facteur présent ($K_T$, $K_f$, $K_W$) de correction de l'influence de paramètres pour la détermination des valeurs du facteur considéré ($K_T$, $K_f$, $K_W$) de correction de l'influence de paramètres.

**18.** Compteur d'électricité à étalonner (1,60) selon la revendication 16, caractérisé en ce que le dispositif (67) de mesure de paramètre contient, selon un montage itératif dans l'ordre indiqué, un capteur (68) de mesure de paramètre pour mesurer en permanence la valeur instantanée d'un paramètre associé (x[t]), un circuit d'échantillonnage et de blocage (69) pour explorer et mémoriser périodiquement les valeurs mesurées du paramètre associé (x[t]), un convertisseur analogique/numérique (70) pour convertir les valeurs d'échantillonnage analogiques ainsi obtenues en valeurs numériques et un codeur (71) pour coder les valeurs numériques en une valeur associée du facteur de correction ($K_T$, $K_f$, $K_W$), qui est envoyé par l'intermédiaire d'une liaison formant bus (73) à un micro-ordinateur (74) contenu dans les compteurs d'électricité (1,60) pour le calcul des valeurs du facteur d'étalonnage et de correction ($K_{gg}$, $K_{gg,j}$).

**19.** Compteur d'electricite a etalonner (1,60) selon l'une des revendications 12 à 18, caractérisé en ce que les compteurs d'électricité à étalonner (1,60) contiennent respectivement un dispositif (75) de mesure de puissance, servant à déterminer la gamme de puissances (a, b, c, d), dans laquelle est située la puissance associée à l'énergie mesurée.

**20.** Compteur d'électricité à étalonner (1,60) selon la revendication 19, caractérisé en ce que le dispositif (75) de mesure de puissance contient un capteur (76) de mesure de puissance, dont la sortie est envoyée à une entrée d'un circuit d'échantillonnage et de blocage (77), que le dispositif (75) de mesure de puissance contient des comparateurs respectifs (78, 79, 80, 81) pour des gammes respectives de puissances (a, b, c, d) pouvant être sélectionnées et que la sortie du circuit d'échantillonnage et de blocage (77) est raccordée à une première entrée des comparateurs (78, 79, 80, 81), aux deux entrées desquels sont appliquées des valeurs limites respectives de puissance (0, P1, P2, P3) des gammes de puissances (a, b, c, d), tandis que les sorties des comparateur (78, 79, 80,81) sont reliées par l'intermédiaire d'une liaison formant bus (82) à un micro-ordinateur (74) contenu dans les compteurs d'électricité (1, 60).

**21.** Condensateur d'électricité à étalonner (1,60) selon la revendication 19, caractérisé en ce que le dispositif (75) de mesure de puissance contient un capteur (76) de mesure de puissance, dont la sortie est reliée à une entrée d'un circuit d'échantillonnage et de blocage (77), dont la sortie est reliée à une entrée analogique d'un convertisseur analogique/numérique (83), dont les sorties numériques sont reliées par l'intermédiaire d'une liaison formant bus (82) à un micro-ordinateur (74) contenu dans les compteurs d'électricité (1, 60), et que des valeurs limites de puissance (0, P1, P2, P3) de la gamme pouvant être selectionnée de puissances (a, b, c, d) sont mémorisées sous forme numérique dans la mémoire (24) du micro-ordinateur (74).

EP 0 569 740 B1

**Fig. 1**

**Fig. 2**

**Fig. 3**

# Fig. 4

# Fig. 5

# Fig. 6

**Fig.7**

**Fig.8**

**Fig.9**

Fig. 10

Fig. 11

Fig. 12

Fig. 13

Fig. 14

# Fig. 15

# Fig. 16

**Fig. 17**

X[t]→ [68] → [69] → [A/D] → [71] ⇒→ [74]

67  70  72  73

**Fig. 18**

F[p]

III  I

II

o   p 1   P1  p2  P2   p3   P3  p 4   p

a   b   c   d

**Fig. 19**

p [t]→ [76] → [77] →

78
O →
79
P 1 →
80
P 2 →
81
P 3 →

[82] ⇒→ [74]

75

**Fig. 20**

p [t]→ [76] → [77] → [83] ⇒→ [74]

82

75